(19) Europäisches Patentamt

European Patent Office

Office européen des brevets

(11) **EP 1 341 221 A1**

(12) **EUROPEAN PATENT APPLICATION**
published in accordance with Art. 158(3) EPC

(43) Date of publication:
**03.09.2003 Bulletin 2003/36**

(51) Int Cl.⁷: **H01L 21/027**, G03F 7/20

(21) Application number: **01997838.6**

(86) International application number:
**PCT/JP01/10184**

(22) Date of filing: **21.11.2001**

(87) International publication number:
**WO 02/043123 (30.05.2002 Gazette 2002/22)**

(84) Designated Contracting States:
**AT BE CH CY DE DK ES FI FR GB GR IE IT LI LU
MC NL PT SE TR**
Designated Extension States:
**AL LT LV MK RO SI**

(30) Priority: **22.11.2000 JP 2000003554**

(71) Applicant: **Nikon Corporation
Tokyo 100-8331 (JP)**

(72) Inventor: **Shiraishi, Naomasa
c/o Nikon Corporation
Tokyo 100-8331 (JP)**

(74) Representative: **Gill, David Alan
W.P. Thompson & Co.,
55 Drury Lane
London WC2B 5SQ (GB)**

(54) **ALIGNER, ALIGNING METHOD AND METHOD FOR FABRICATING DEVICE**

(57)  In an exposure apparatus (100), a main controller (50) calculates the thickness of a light transmitting protective member that protects a pattern surface of a mask (R), based on detection signals of a first and second reflection beams of a detection beam irradiated from an irradiation system (20a), reflected off the front and back surfaces of the protective member, and received by a photodetection system (20b). This makes exposure that takes into account the variation in the image forming state of the image pattern depending on the calculated thickness of the protective member possible. Accordingly, exposure with high precision is possible, without the difference in thickness of the protective member protecting the pattern surface of the mask affecting the exposure. In addition, when the incident angle of the detection beam is optimized, setting a detection offset in the photodetection system, or resetting the origin will not be necessary.

*Fig. 1*

EP 1 341 221 A1

**Description**

*TECHNICAL FIELD*

The present invention relates to exposure apparatus, exposure methods, and device manufacturing methods, and more particularly, to an exposure apparatus and an exposure method used in a lithographic process when manufacturing devices such as a semiconductor device or a liquid crystal display device, and a device manufacturing method using the exposure apparatus and exposure method.

*BACKGROUND ART*

In a conventional photolithographic process for manufacturing devices such as semiconductors, various exposure apparatus have been used. In recent years, projection exposure apparatus such as a reduction projection exposure apparatus based on a step-and-repeat method (a so-called stepper) that reduces and transfers a pattern of a mask (also called a reticle), which is made four to five times larger than the pattern to be formed, onto a substrate subject to exposure such as a wafer via a projection optical system, and a scanning projection exposure apparatus based on a step-and-scan method (a so-called scanning stepper), which is an improvement of the stepper, are being widely used.

In such projection exposure apparatus, exposure wavelength is becoming shorter in order to cope with finer integrated circuits and achieve high resolution. At present, the exposure wavelength 248nm of a KrF excimer laser is mainstream, however, the exposure wavelength of an ArF excimer laser having a wavelength of 193nm, which is shorter than that of the KrF excimer laser, is now entering the stage of practical usage. With exposure apparatus having such exposure wavelengths, transmittance decreases due to exposure light being absorbed by substances in the air (mainly organic matters), and the organic matters being activated by the exposure light and adhering on lenses or the like. Therefore, in order to remove the organic matters from the optical path of the exposure light, it is considered effective to fill the space along the optical path with air or other gases that does not contain any organic matters.

In addition, when contaminants such as dust or chemical impurities adhere on a pattern surface of a mask or a reticle (hereinafter generally referred to as a "reticle") on which a pattern is formed, it reduces the transmittance in that area, which is likely to be a cause of a pattern transfer error on exposure when the contaminant is transferred onto the wafer. Therefore, the pattern surface of the reticle is normally covered with a membrane member called a pellicle, in order to prevent foreign materials such as dust from adhering onto the pattern surface and entering within the depth of focus.

It appears certain that shorter exposure wavelength will be required in the future. Therefore, projection exposure apparatus are being developed that use a light source which light belongs to a vacuum ultraviolet region having a shorter wavelength than the ArF excimer laser, such as an $F_2$ laser having an output wavelength of 157nm or an $Ar_2$ laser having an output wavelength of 126nm, and proposals are being made on such apparatus.

Beams in such wavelength range called the vacuum ultraviolet region, however, have low transmittance to optical glass, and materials that can be used for the lenses or the reticle are limited to fluorite or fluoride crystal such as magnesium fluoride or lithium fluoride. In addition, these beams are greatly absorbed by oxygen, water vapor, and typical organic matters (hereinafter referred to as "absorptive gas"). Therefore, in an exposure apparatus that uses a light beam in the vacuum ultraviolet region as the exposure light, it is necessary to replace gases existing on an optical path of the exposure light with gases which absorption of vacuum ultraviolet light is low, that is, inert gas such as nitrogen or helium (hereinafter referred to as "low absorptive gas" as appropriate), so as to lower the concentration of the absorptive gases existing on the optical path so that it falls within the range of several ppm.

Conventional pellicles, however, are made from a membrane which main constituent is an organic matter such as nitrocellulose. Therefore, the possibility of the transmittance of the exposure light decreasing is high, due to the pellicle itself absorbing the exposure light or degassing from the pellicle, when a vacuum ultraviolet light is used as the exposure light.

Therefore, in an exposure apparatus using exposure light in the vacuum ultraviolet region, instead of using the membrane referred to earlier, a thick pellicle (hard pellicle) can be employed that is made up of a relatively thick plate member (for example, around 300 to 800μm thick, or thicker) being made from a material that has good transmittance to vacuum ultraviolet light, such as the above fluoride crystal or fluorine-doped quartz. When such hard pellicle is used, the thickness of the entire pellicle may not be the same and may differ partially within the same pellicle, which may reduce the image forming performance due to a refraction phenomenon of the exposure light.

The present invention has been made considering such situations, and has as its first object to provide an exposure apparatus that can perform exposure with high precision, without being affected by a difference in thickness of a protective member (pellicle) protecting a pattern surface of a mask.

In addition, it is the second object of the present invention to provide an exposure method of performing exposure with high precision, without being affected by the difference in thickness of the protective member (pellicle) protecting the pattern surface of the mask.

And, it is the third object of the present invention to provide a device manufacturing method that can improve yield and productivity when producing high integration microdevices.

## DISCLOSURE OF INVENTION

According to the first aspect of the present invention, there is provided a first exposure apparatus that irradiates an energy beam on a mask and transfers a pattern formed on the mask onto a substrate, the exposure apparatus comprising: a detection unit that detects the thickness of a light transmitting protective member protecting a pattern surface of the mask on which the pattern is formed.

With the exposure apparatus, since it comprises a detection unit that detects the thickness of the light transmitting protective member that protects the pattern surface of the mask, the detection unit makes it possible to perform exposure that takes into account the variation in the image forming state of the image pattern, depending on the calculated thickness of the protective member. Accordingly, exposure with high precision is possible, without it being affected by the difference in thickness of the protective member (pellicle) protecting the pattern surface of the mask.

When the light transmitting protective member is made from a transparent plate made of a parallel plate, the detection unit can have an irradiation system that irradiates a detection beam with respect to the pattern surface from an oblique direction at a predetermined angle via the transparent plate, a first photodetection unit that receives a first reflection beam and a second reflection beam reflected off a surface facing the pattern surface of the transparent plate and a surface on the opposite side of the surface, respectively, and outputs detection signals, respectively, and a computing unit that calculates the thickness of the transparent plate based on the detection signals output from the first photodetection unit.

The surface on the opposite side is the incident surface on which the detection beam enters the transparent plate, and the surface facing the pattern surface is the outgoing surface of the detection beam from the transparent plate.

In this case, the detection unit can further have a second photodetection unit that receives a third reflection beam reflected off the pattern surface and outputs its detection signal, and the computing unit can further calculate a position of the pattern surface in a normal direction, based on detection signals output from the first photodetection unit and a detection signal output from the second photodetection unit.

In this case, the computing unit can include a first calculation unit that calculates the thickness of the transparent plate, based on detection signals output from the first photodetection unit, and a second calculation unit that calculates a position of the pattern surface in a normal direction, based on the thickness of the transparent plate calculated by the first calculation unit and a detection signal output from the second photodetection unit.

With the first exposure apparatus in the present invention, when the detection unit has a first and second photodetection unit, and the computing unit also calculates the position of the pattern surface in the normal direction, based on the output signals of these photodetection units, the detection unit can further have a calibration unit that calibrates the second photodetection unit, based on detection signals output from the first photodetection unit.

In this case, the calibration unit can calibrate the second photodetection unit by shifting an optical axis of a reflection beam reflected off the pattern surface.

In this case, the calibration unit can include a parallel plate arranged along an optical path of the reflection beam from the pattern surface to the second photodetection unit, and inclination of the parallel plate can be changed with respect to the optical axis of the reflection beam.

With the first exposure apparatus in the present invention, when the light transmitting protective member is formed of a transparent plate made of a parallel plate and the detection unit has a first and second photodetection unit, the exposure apparatus can further comprise a projection optical system which is arranged so that its optical axis is made to match the normal direction, and projects the energy beam outgoing from the mask onto the substrate; and a correction unit that corrects at least one of a positional relationship between the mask and the substrate and optical properties of the projection optical system, based on the thickness of the transparent plate calculated by the computing unit.

In this case, the irradiation system can irradiate detection beams onto each of a plurality of detection points within an area on the pattern surface that corresponds to an exposure area of the projection optical system illuminated by the energy beam, the first photodetection units can be arranged in plurals, individually corresponding to each of the plurality of detection points, the computing unit can calculate a distribution of thickness of the transparent plate, based on detection signals from the plurality of first detection units, and the correction unit can adjust an inclination of at least one of the mask and the substrate with respect to a surface perpendicular to the optical direction of the projection optical system.

According to the second aspect of the present invention, there is provided a second exposure apparatus that irradiates an energy beam on a mask and transfers a pattern formed on the mask onto a substrate, the exposure apparatus comprising: a position detection system that has an irradiation system that irradiates a detection beam on a pattern surface of the mask on which the pattern is formed at an incident angle $\alpha$ via a light transmitting transparent plate, which has a predetermined thickness and protects the pattern surface, a photodetection unit that receives a reflection beam reflected off the pattern surface and outputs its detection signal, and a calculation unit that calculates a position of the pattern surface in a normal direction of the pattern surface, based on an output of the photodetection unit; and a projection optical system which optical axis is in the normal direction and projects the energy beam outgoing from the mask onto the substrate, whereby when an outgoing angle of the detection beam entering the transparent plate is expressed as $\beta$, a maximum angle of an incident angle of the energy beam to the transparent plate is expressed as $\alpha'$, the maximum angle of the incident angle of the energy beam being set by a numeric aperture and a projection magnification of the projection optical system, and an outgoing angle of the energy beam entering the transparent plate is expressed as $\beta'$, the incident angle $\alpha$ is set to satisfy a relation expressed as: $\tan\beta/\tan\alpha=\tan\beta'/\tan\alpha'$.

With the exposure apparatus, since the incident angle $\alpha$ of the detection beam is set to satisfy $\tan\beta/\tan\alpha=\tan\beta'/\tan\alpha'$ when the outgoing angle of the detection beam entering the transparent plate is expressed as $\beta$, the maximum angle of the incident angle of the energy beam to the transparent plate is expressed as $\alpha'$, the maximum angle of the incident angle of the energy beam being set by a numeric aperture and a projection magnification of the projection optical system, and the outgoing angle of the energy beam entering the transparent plate is expressed as $\beta'$, the displacement in the focal position of the energy beam coincides with the displacement in the detection position of the detection beam, regardless of the thickness of the transparent plate. Therefore, the position of the pattern surface of the mask in the optical axis direction or the amount of defocus can be detected with high precision, without re-setting the detection reference position (position of origin) and without being affected by the transparent plate. Accordingly, the pattern surface of the mask and the surface of the substrate subject to exposure can be set at a preferable optical positional relationship, and exposure with high precision becomes possible without any defocusing.

In this case, light such as an ArF excimer laser beam having the wavelength of 193nm can be used as the energy beam, however, when the energy beam is an $F_2$ laser beam having a wavelength of 157nm, and the incident angle $\alpha$ is preferably set within the range of 30° to 50°, or more preferably, within the range of 35° to 40°.

With the second exposure apparatus in the present invention, light having various wavelengths can be used. For example, when the energy beam is an $F_2$ laser beam having a wavelength of 157nm, and the incident angle $\alpha$ of the detection beam is set within the range of 30° to 50°, the detection beam may be a red light that belongs to the wavelength bandwidth of 600nm to 800nm, and the transparent plate may be made of a fluorine-doped quartz.

With the second exposure apparatus in the present invention, it can further comprise a correction unit that corrects optical properties of the projection optical system based on a thickness t of the transparent plate.

In this case, thickness t may be input from the outside, however, the exposure apparatus may further comprise a detection unit that detects the thickness t. In this case, as the detection unit, for example, a unit that has the first photodetection unit (and the second photodetection unit) and the computing unit can be used.

According to the third aspect of the present invention, there is provided a third exposure apparatus that irradiates an energy beam on a mask and transfers a pattern formed on the mask onto a substrate, the exposure apparatus comprising: an irradiation system that irradiates a detection beam on a pattern surface of the mask on which the pattern is formed from a direction of a predetermined angle of inclination via a light transmitting transparent plate, which has a predetermined thickness and protects the pattern surface; a position detection unit that receives a reflection beam reflected off the pattern surface, and detects a position of the pattern surface in a normal direction, and a calibration unit that calibrates the position detection unit, based on the thickness of the transparent plate.

With the exposure apparatus, the calibration unit calibrates the position detection unit based on the thickness of the transparent plate protecting the pattern surface of the mask. And, when the detection beam is irradiated on the mask from the irradiation system via the transparent plate, the reflection beam is received by the position detection unit to which calibration has been performed, and the position of the pattern surface in the normal direction is precisely detected without being affected by the thickness of the transparent plate, that is, regardless of whether the transparent plate is provided or not. Accordingly, the positional relationship (including optical positional relationship) between the pattern surface of the mask and the surface of the substrate subject to exposure can be preferably set, and exposure with high precision becomes possible.

In this case, when the exposure apparatus further comprises a thickness detection unit that detects the thickness of the transparent plate, wherein the calibration unit can calibrate the position detection unit, based on detection results of the thickness detection unit.

According to the fourth aspect of the present invention, there is provided a first exposure method in which an energy beam exposes a substrate via a mask on which a pattern is formed to transfer an image of the pattern on the substrate, the exposure method including: a detection process in which the thickness of a light transmitting protective member protecting a pattern surface of the mask where the pattern is formed is detected; and a correction process in which an image forming state of the pattern is corrected, based on the thickness of the light transmitting protective member detected in the detection process.

With this method, since the thickness of the light transmitting protective member protecting the pattern surface of the mask is detected, and the correction of the image forming state of the image formed on the substrate is performed based on the thickness of the protective member, this makes exposure with high precision possible that takes into account the image forming state of the image pattern and its variation, depending on the calculated thickness of the protective member.

In this case, when the light transmitting protective member is made from a transparent plate made of a parallel plate, the detection process can include an irradiation process in which a detection beam is irradiated from a direction of a predetermined inclination with respect to a normal line of the pattern surface via the transparent plate, a photodetection process in which a first reflection beam and a second reflection beam reflected off a surface facing the pattern surface of the transparent plate and a surface on the opposite side of the surface facing the pattern surface are received, respectively, and a calculation process in which the thickness of the transparent plate is calculated based on detection results of the first and second reflection beams.

In this case, in the photodetection process, a third reflection beam from the pattern surface can be further received, and in the calculation process, a position of the pattern surface in the normal direction can be further calculated, based on photodetection results of the first, second, and third reflection beams.

In this case, calculating a position of the pattern surface in the normal direction can include a first calculation process in which the thickness of the transparent plate is calculated, based on the photodetection results of the first and second reflection beams, and a second calculation process in which the position of the pattern surface in the normal direction is calculated, based on the calculated thickness of the transparent plate and photodetection result of the third reflection beam.

According to the fifth aspect of the present invention, there is provided a second exposure method in which an energy beam is irradiated on a mask, and a pattern formed on the mask is transferred onto a substrate via a projection optical system, the exposure method including: a process of irradiating a detection beam on a pattern surface of the mask on which the pattern is formed at an incident angle $\alpha$ via a light transmitting transparent plate, which has a predetermined thickness and protects the pattern surface; and a process of calculating a position of the pattern surface in an optical axis direction of the projection optical system, which is a normal direction of the pattern surface, when a reflection beam reflected off the pattern surface is received based on its results, whereby when an outgoing angle of the detection beam entering the transparent plate is expressed as $\beta$, a maximum angle of an incident angle of the energy beam to the transparent plate is expressed as $\alpha'$, the maximum angle of the incident angle of the energy beam being set by a numeric aperture and a projection magnification of the projection optical system, and an outgoing angle of the energy beam entering the transparent plate is expressed as $\beta'$, the incident angle $\alpha$ is set to satisfy a relation expressed as: $\tan\beta/\tan\alpha=\tan\beta'/\tan\alpha'$.

With this method, the detection beam is irradiated on the pattern surface at the incident angle $\alpha$ via the light transmitting transparent plate, which has a predetermined thickness and protects the pattern surface of the mask, and the position of the pattern surface in the optical axis direction of the projection optical system, which is the normal direction of the transparent plate, is calculated, based on the photodetection result of the reflection beam of the detection beam reflected off the pattern surface. In this case, since the incident angle $\alpha$ of the detection beam is set to satisfy $\tan\beta/\tan\alpha=\tan\beta'/\tan\alpha'$ when the outgoing angle of the detection beam entering the transparent plate is expressed as $\beta$, the maximum angle of the incident angle of the energy beam to the transparent plate is expressed as $\alpha'$, the maximum angle of the incident angle of the energy beam being set by a numeric aperture and a projection magnification of the projection optical system, and the outgoing angle of the energy beam entering the transparent plate is expressed as $\beta'$, the displacement in the focal position of the energy beam coincides with the displacement in the detection position of the detection beam, regardless of the thickness of the transparent plate. Therefore, based on the reflection beam, the position of the pattern surface of the mask in the optical axis direction or the amount of defocus can be detected with high precision, without being affected by the transparent plate. Accordingly, the pattern surface of the mask and the surface of the substrate subject to exposure can be set at a preferable optical positional relationship, and exposure with high precision becomes possible without any defocusing.

According to the sixth aspect of the present invention, there is provided a third exposure method in which an energy beam having a wavelength of 157nm is irradiated on a mask, and a pattern formed on the mask is transferred onto a substrate via a projection optical system, the exposure method including: a process of irradiating a detection beam on a pattern surface of the mask on which the pattern is formed in an incident angle range of 30° to 50°; and a process of calculating a position of the pattern surface in an optical axis direction of the projection optical system when a reflection beam of the detection beam reflected off the pattern surface is received, based on its results.

With this method, when the reflection beam of the detection beam reflected off the pattern surface is received, which is irradiated at an incident angle range of 30° to 50° on the pattern surface of the mask, the position of the pattern surface in the optical axis direction of the projection optical system is calculated based on the photodetection results. For example, when a transparent plate is provided in the vicinity of the pattern of the mask, by irradiating the detection beam on the pattern surface at an incident angle within the range of 30° to 50°, the detection error of the position of the pattern surface due to the transparent plate and the displacement of the focal position of the energy beam due to the transparent plate becomes almost equal. This removes almost all the influence that the detection error of the position of the pattern surface has on the exposure accuracy, therefore, exposure with high precision is possible, even when the exposure is controlled in a manner similar to when there is no transparent plate provided.

In this case, the incident angle is preferably an angle in the range of 35° to 40°.

According to the seventh aspect of the present invention, there is provided a fourth exposure method in which an energy beam is irradiated on a mask, and a pattern formed on the mask is transferred onto a substrate, the exposure method including: an irradiation process in which a detection beam is irradiated on a pattern surface of the mask on which the pattern is formed from a direction of a predetermined angle of inclination via a light transmitting transparent plate, which has a predetermined thickness and protects the pattern surface; and a position detection/correction process in which a position of the pattern surface in a normal direction is detected when a reflection beam reflected off the pattern surface is received and the position of the pattern surface in the normal direction is corrected, based on the thickness of the transparent plate.

With this method, when the detection beam is irradiated on the pattern surface via the transparent plate, the position of the pattern surface is detected in the normal direction by receiving the reflection beam. And, on detection, the position of the pattern surface in the normal direction is corrected, base on the thickness of the transparent plate. As a consequence, the position of the pattern surface on which position correction has been performed is detected in the normal direction. That is, the position of the pattern surface in the normal direction is precisely detected, without being affected by the thickness of the transparent plate, or in other words, regardless of whether the transparent plate is provided or not. Accordingly, the positional relationship (including optical positional relationship) between the pattern surface of the mask and the surface of the substrate subject to exposure can be preferably set, and exposure with high precision becomes possible.

In this case, when the method further includes: a detection process detecting the thickness of the transparent plate, in the position detection/correction process, the position of the pattern surface in the normal direction can be corrected, based on the thickness of the transparent plate detected in the detection process.

With the fourth exposure method in the present invention, in the position detection/correction process, the position of the pattern surface in the normal direction can be detected using a position detection unit, and the position detection unit can be calibrated to correct the position, based on the thickness of the transparent plate.

In addition, in a lithographic process, by performing exposure using any one of the first to third exposure apparatus in the present invention, exposure with high precision can be performed, which allows high integration microdevices to be produced with high yield, improving the productivity. Likewise, in a lithographic process, by performing exposure unit any one of the first to fourth exposure methods in the present invention, patterns can be formed with high precision on substrates, which allows high integration microdevices to be produced with high yield, improving the productivity.

Accordingly, in the present invention, furthermore from another aspect, there is provided a device manufacturing method using any one of the first to third exposure apparatus in the present invention, or in other words, a device manufacturing method using any one of the first to fourth exposure methods in the present invention.

## BRIEF DESCRIPTION OF THE DRAWINGS

Fig. 1 is a view showing an entire configuration of an exposure apparatus related to a first embodiment in the present invention;

Fig. 2 is a view schematically showing a reticle in Fig. 1 and a reticle AF system;

Fig. 3 is a view for describing an arrangement of a reticle AF system;

Fig. 4 is a view for describing a focus position alignment related to the first embodiment;

Fig. 5 is a view for describing an arrangement of a reticle AF system related to a second embodiment in the present invention;

Figs. 6A to 6C are views for describing a focus position alignment related to the second embodiment;

Fig. 7 is a graph showing a relation between an incident angle $\theta_1$ and displacement in focal position Z;

Fig. 8 is a flow chart for explaining an embodiment of a device manufacturing method according to the present invention; and

Fig. 9 is a flow chart for showing a process in step 204 in Fig. 8.

***Best Mode for Carrying out the Invention***

<<First Embodiment>>

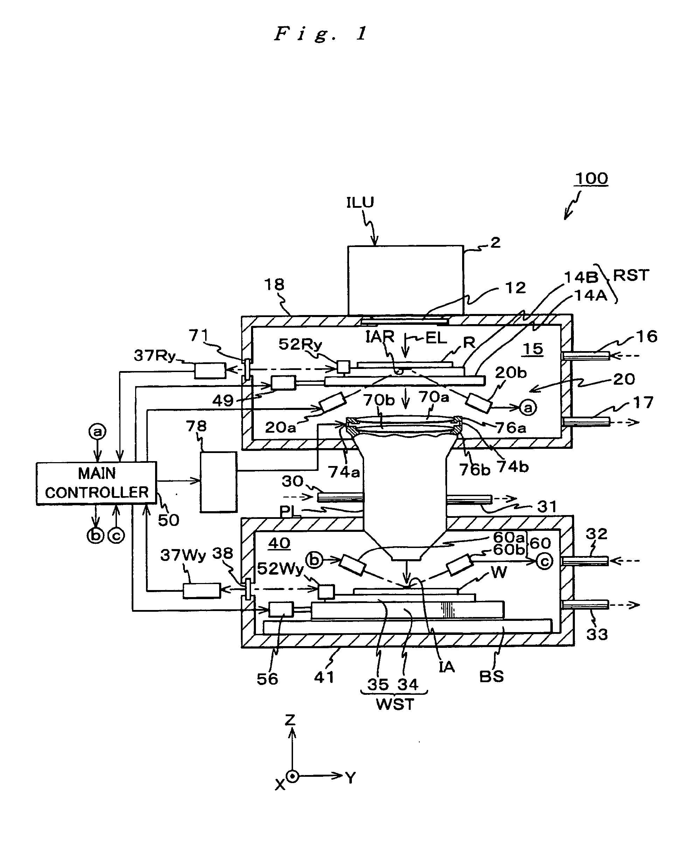

Following is a description of a first embodiment related to the present invention, referring to Figs. 1 to 4. Fig. 1 shows an entire configuration of an exposure apparatus 100 in the first embodiment. Exposure apparatus 100 is a projection exposure apparatus based on a step-and-scan method, that is, a so-called scanning stepper that transfers a pattern of a reticle R serving as a mask onto a wafer W serving as a substrate via a projection optical system PL, by irradiating an exposure illumination light EL serving as an energy beam in the vacuum ultraviolet region onto reticle R and synchronously moving reticle R and wafer W in a predetermined direction (in this case, in a Y-axis direction which is the lateral direction of the page surface in Fig. 1).

Exposure apparatus 100 includes a light source and an illumination unit ILU, and comprises: an illumination system that illuminates reticle R with exposure illumination light (hereinafter referred to as "exposure light") EL; a reticle stage RST serving as a mask stage that holds reticle R; a projection optical system PL that projects exposure light EL emitted from reticle R onto wafer W; a wafer stage WST serving as a substrate stage that holds wafer W; a control system that controls these sections, and the like.

As the light source, in this case, a light source that emits light belonging to the vacuum ultraviolet region in the wavelength range of approximately 120nm to 180nm is used, such as a fluorine laser ($F_2$ laser) that has an output wavelength of 157nm. The light source is connected to one end of an illumination system housing 2, which makes up illumination unit ILU, via a light transmitting system (not shown). A part of the light transmitting system is an optical system called a beam matching unit for optical axis adjustment. In actual, the light source is arranged in a service room in which the degree of cleanliness is lower than that of a clean room where the exposure apparatus main body including units such as illumination unit ILU and projection optical system PL are arranged, or in a utility space underneath the floor of the clean room. As the light source, other vacuum ultraviolet light sources may be used, such as a krypton dimer laser ($Kr_2$ laser) having an output wavelength of 146nm, or an argon dimer laser ($Ar_2$ laser) having an output wavelength of 126nm. Or, an ArF excimer laser having an output wavelength of 193nm, a KrF excimer laser having an output wavelength of 248nm, or the like, may also be used.

Illumination unit ILU is structured including: illumination system housing 2 that isolates the inside from the outside; an illuminance uniformity optical system including parts such as an optical integrator that are arranged inside illumination system housing 2 in a predetermined positional relationship; and an illumination optical system made up of parts such as a relay lens, a variable ND filter, a reticle blind, and a dichroic mirror (all of which are not shown). The arrangement of the illumination optical system is similar to the ones disclosed in, for example, Japanese Patent Application Laid-open No. 10-112433 and Japanese Patent Application Laid-open No. 06-349701, and the corresponding U.S. Patent No. 5,534,970. As the optical integrator, a fly-eye lens is used in the embodiment. However, a rod integrator (internal reflection type), a diffraction optical element, or the like may also be used. As long as the national laws in designated states or elected states, to which this international application is applied, permit, the disclosure of the U. S. Patent cited above is fully incorporated herein by reference.

Illumination unit ILU illuminates a slit-shaped illumination area (a slit shaped area set by the reticle blind, which extends narrowly in an X-axis direction) on reticle R where a circuit pattern or the like is formed with exposure light EL in a uniform illuminance distribution.

When light which wavelength is in the vacuum ultraviolet region is used as the exposure light, gases that greatly absorb light of such wavelength bandwidth, such as oxygen, water vapor, hydrocarbon gas, and organic matters (hereinafter referred to as "absorptive gas" as appropriate) have to be eliminated from the optical path. Therefore, in the embodiment, the inside of illumination system housing 2 is filled with a specific gas which has low absorption to light in the vacuum ultraviolet region such as nitrogen, rare gas such as helium, argon, neon, or krypton, or a mixture of these gases (hereinafter referred to as "low absorptive gas" as appropriate). As a consequence, the concentration of the absorptive gases in the illumination system housing 2 falls within several ppm.

In the embodiment, the light source and the optical path inside the light transmitting system is also filled with the low absorptive gas, as in illumination system housing 2.

Reticle stage RST is arranged in a reticle chamber 15, holding reticle R. Reticle chamber 15 is enclosed with a partition wall 18, which is tightly connected without any gap to illumination system housing 2 and the barrel of projection optical system PL, and the gas inside is isolated from the outside. Partition wall 18 of reticle chamber 15 is formed of a material such as stainless steel (SUS), which releases only a small amount of gas when degassed.

In the ceiling portion of partition wall 18 of reticle chamber 15, a small rectangular opening is formed, which is slightly smaller than the reticle R. In the opening, a light transmittance window 12 is arranged so as to separate the space inside illumination system housing 2 and that of the reticle chamber 15 where the reticle R to be exposed is arranged. Since light transmittance window 12 is arranged on the optical path of exposure light EL emitted from illumination unit ILU to the reticle R, it is made of a crystal material that has high transmittance to vacuum ultraviolet light serving as exposure light EL, such as fluorite.

Reticle stage RST is structured so that it can drive reticle R linearly with large strokes in the Y-axis direction on a reticle base supporting bed (not shown), as well as drive reticle R finely in the X-axis direction and a θz direction (a rotational direction around a Z-axis).

More particularly, reticle stage RST comprises a reticle scanning stage 14A, which is driven in the Y-axis direction with predetermined strokes on the reticle base supporting bed (not shown) by a reticle drive system 49 that includes a linear motor or the like, and a reticle holder 14B which holds reticle R mounted on reticle scanning stage 14A by suction. Reticle holder 14B is structured finely drivable (including rotation) within an XY plane by reticle drive system 49.

Inside reticle chamber 15, a flow of the low absorptive gas such as helium gas (or nitrogen gas) is created at all times. This is because in an exposure apparatus which exposure wavelength is in the vacuum ultraviolet region, the vicinity of reticle R needs to be replaced with low absorptive gas so as to prevent the exposure light from being absorbed by the absorptive gas such as oxygen. Thus, concentration of the absorptive gas in reticle chamber 15 is also maintained below several ppm.

As is shown in Fig. 1, one end of a gas supply pipeline 16 and an exhaust pipeline 17 are each connected to partition wall 18 of reticle chamber 15. The other end of gas supply pipeline 16 and exhaust pipeline 17 are each connected to a helium gas supply unit (not shown). Helium gas having high purity is supplied to reticle chamber 15 from the helium gas supply unit via gas supply pipeline 16 at all times, whereas the gas within reticle chamber 15 is collected by the helium gas supply unit via exhausting pipeline 17. The helium gas is circulated and used in such manner. The helium gas supply unit incorporates a gas purifying unit, and the gas purifying unit operates so as to maintain concentration of gases other than the helium gas (that is, absorptive gases such as oxygen, water vapor, or organic matters) less than several ppm, even when the helium gas is circulated and used for over a long period of time in a circulation route including the helium gas supply unit and the inside of reticle chamber 15. Sensors such as a pressure sensor or an absorptive gas concentration sensor may be arranged within reticle chamber 15, and based on measurement values of the sensor, the start/stop operation of a pump incorporated in the helium gas supply unit may be controlled appropriately via a control unit (not shown).

On the side wall in the -Y side of partition wall 18 of reticle chamber 15, a light transmittance window 71 is arranged. Likewise, although it is omitted in the drawings, a light transmittance window is also arranged on the side wall in the -X side (in depth of the page surface in Fig. 1) of partition wall 18. These light transmittance windows are structured, by forming windows (opening portions) in partition wall 18 and attaching light transmitting members to close the windows, in this case, a normal optical glass. When the windows are formed, in order to prevent gas leakage from where the light transmitting member configuring light transmittance window 71 is attached to the window opening, sealing with a metal seal such as indium or copper, or a fluorocarbon resin is applied to the attached portion. As the above fluorocarbon resin, a fluorocarbon resin that has been degassed by undergoing heat treatment for two hours at a temperature of 80°c is preferably used.

On the edge portion on the -Y side of reticle holder 14B, a Y movable mirror 52Ry consisting of a planar mirror is arranged, extending in the X-axis direction. On Y movable mirror 52Ry, measurement beams from a Y-axis laser interferometer 37Ry arranged outside reticle chamber 15 almost at a right angle to Y movable mirror 52Ry are projected, via light transmittance window 71. A detector which receives the light reflected off Y movable mirror 52Ry via light transmittance window 71 is arranged within the Y-axis laser interferometer 37Ry, thus detecting a position of the Y movable mirror 52Ry, that is, a Y position of reticle R, with a position of a reference mirror arranged within Y-axis laser interferometer 37Ry as a reference.

Similarly, although it is omitted in the drawings, on the edge portion on the -X side of reticle holder 14B, an X movable mirror consisting of a planar mirror is arranged, extending in the Y-axis direction. And, similar as above, a position of X movable mirror, that is, an X position of reticle R is detected with an X-axis interferometer (not shown) via X movable mirror. Detection values (measurement values) of the above two laser interferometers are supplied to a main controller 50, and main controller 50 controls the position of reticle stage RST based on the detection values of these interferometers.

As is described, in the embodiment, since the laser interferometers, or in other words, the laser light source, optical members such as a prism, and the detectors or the like, are arranged outside reticle chamber 15, there are no adverse effects on exposure, even if a small amount of absorptive gas is generated from parts making up the laser interferometers such as the detectors.

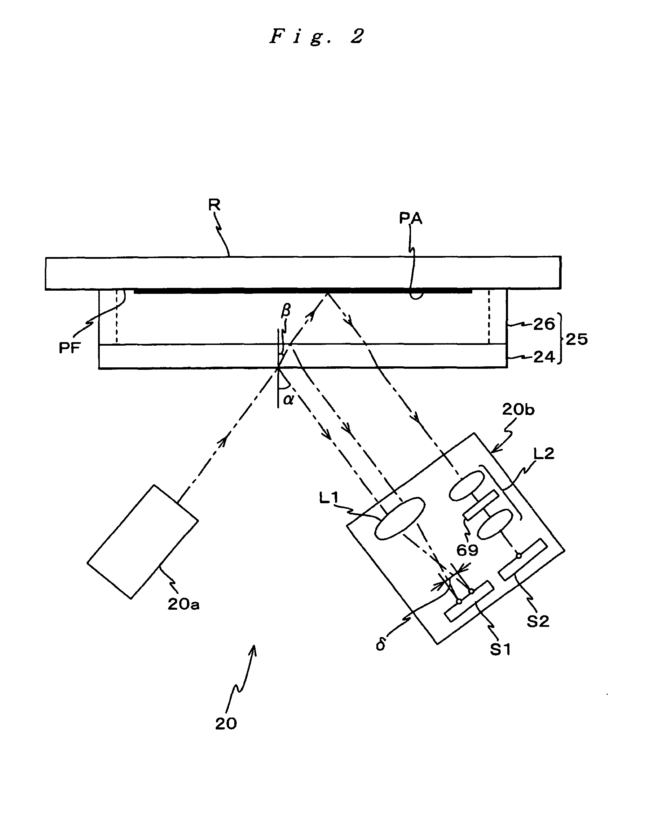

Fig. 2 shows reticle R being held by reticle holder 14B. As is shown in Fig. 2, on a surface PF of reticle R (the lower surface in Figs. 2 and 1), a circuit pattern PA is formed. Hereinafter, the surface on which circuit pattern PA is formed will be referred to as "pattern surface PF".

On pattern surface PF, a reticle protection unit 25 is attached. As is shown in Fig. 2, reticle protection unit 25 comprises: a metal frame 26 attached to pattern surface PF of reticle R that has a rectangular shape when viewed from below; and a hard pellicle 24 (transparent plate) fixed on a surface of frame 26 opposite to pattern surface PF, serving as a protective member. In this case, due to reticle protection unit 25, or mainly by hard pellicle 24, dust or chemical impurities can be kept from adhering and accumulating on pattern surface PF of reticle R. Incidentally, frame 26 can be made of either the same or a different material as the protective member, which will be described later in the description.

Hard pellicle 24 is arranged parallel to pattern surface PF, at a position around 6.3mm below pattern surface PF of reticle R and is for example, around 300 to 800$\mu$m thick, or thicker.

In the embodiment, as exposure light EL, the $F_2$ laser beam is used as is previously described. Since the $F_2$ laser beam has low transmittance, not only to gases such as oxygen and water vapor but also to glass and organic matters, reticle R and the hard pellicle need to be made of materials that have high transmittance to vacuum ultraviolet light. In the embodiment, for example, a fluorine-doped quartz which hydroxyl group is eliminated to the level of around 10ppm or under while containing around 1% fluorine is used as the material for reticle R and hard pellicle 24.

In addition, the gas in the space enclosed with pattern surface PF and frame 26 and the protective member (such as hard pellicle 24) also needs to be replaced with the low absorptive gas.

Referring back to Fig. 1, a reticle focal position detection system (hereinafter referred to as "reticle AF system") 20 is arranged below reticle stage RST. Reticle focal position detection system 20 includes an irradiation system 20a that has a light source which operation is controlled by main controller 50 and irradiates a detection beam from an oblique direction toward pattern surface PF of reticle R, and a photodetection system 20b that detects the beam reflected off pattern surface PF or the like.

As is schematically shown in Fig. 2, reticle AF system 20 comprises: irradiation system 20a; and photodetection system 20b, which is structured including a first photodetection unit S1 and a second photodetection unit S2. Irradiation system 20a irradiates a detection beam on pattern surface PF of reticle R via hard pellicle 24, or in other words, irradiates an imaging beam for forming pinhole or slit images. Photodetection system 20b includes the first photodetection unit S1, which photo-detects the reflection beams of the imaging beam emitted from irradiation system 20a reflected off the upper and lower surfaces of hard pellicle 24 via a photodetection optical system L1, and the second photodetection unit S2, which is arranged in the vicinity of photodetection optical system L1 and the first photodetection unit S1, and photo-detects the reflection beam of the imaging beam reflected off pattern surface PF of reticle R via a photodetection optical system L2.

Irradiation system 20a is formed including: for example, a light source (not shown) such as a light emitting diode that irradiates a red light belonging to the wavelength bandwidth of around 600 to 800nm serving as a detection beam; an aperture plate on which a pinhole or slit-shaped aperture is formed; and an irradiation objective lens, and irradiates the imaging beam toward illumination area IAR on pattern surface PF of reticle R at a predetermined incident angle.

Photodetection optical system L1 is structured, including a photodetection objective lens and other optical elements. Also, as the first photodetection unit S1, for example, a licensor is used. The first photodetection unit S1 photo-detects the reflection beams of the imaging beams irradiated from the irradiation system 20a and reflected off both the upper surface (the surface that faces pattern surface PF of reticle R) and the lower surface of hard pellicle 24, and outputs each of the detection signals to main controller 50.

Photodetection optical system L2 is made up of optical elements including a parallel plate (plane-parallel plate) 69, besides a photodetection objective lens. And, as the second photodetection unit S2, for example, a photodetection device that can detect the photodetection position such as a two-dimensional CCD or a quartered photodetection device is used. The second photodetection unit S2 photo-detects the reflection beams of the imaging beams irradiated from the irradiation system 20a and reflected off pattern surface PF of reticle R, and outputs the detection signals to main controller 50. In addition, the reason for arranging parallel plate 69 within photodetection optical system L2 is because by changing the tilt of parallel plate 69 with respect to optical axis of the reflection beam, it can shift the optical axis of the reflection beam entering the second photodetection unit S2. And as a consequence, calibration (resetting of the origin) of the second photodetection optical system L2 is performed. In the embodiment, main controller 50 controls an angle of inclination of parallel plate 69 via a drive system (not shown), and the optical axis can be shifted according to the angle of inclination. That is, in the embodiment, a calibration unit is formed, including parallel plate 69, the drive system for parallel plate 69, and main controller 50.

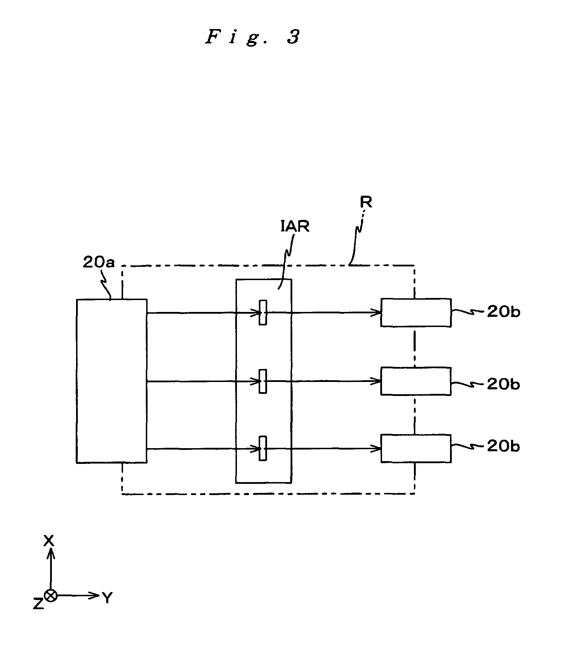

Although it is not shown in Figs. 1 and 2, in actual, as is shown in Fig. 3, irradiation system 20a irradiates an imaging beam on each of a plurality of detection points (three, in this case) arranged at a predetermined interval in a non-scanning direction (the X-axis direction) within illumination area IAR (an area corresponding to an exposure area of projection optical system PL, which will be described later on) on pattern surface PF of reticle R, and photodetection system 20b is provided corresponding individually to each of the detection points. And, irradiation system 20a and the three photodetection systems 20b make up a multiple focal point detection system.

In this case, irradiation system 20a can employ a structure of irradiating the above three imaging beams by dividing light from a single light source into three beams via an optical system, or it can employ a structure of using three light sources to form each of the imaging beams.

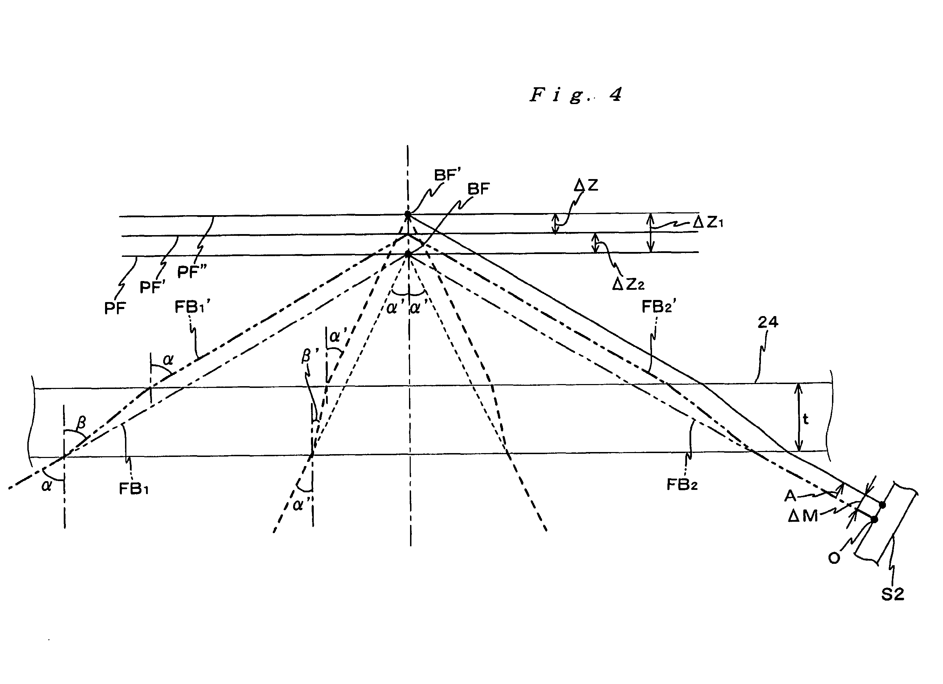

As is obvious from Fig. 4, the irradiation direction and reflection direction of the imaging beams (detection beams) are not limited only within a YZ plane as is shown in Fig. 3, but can be set within an XZ plane or any other planes so long as it is a plane intersecting with respect to the XY plane at a predetermined angle.

Referring back to Fig. 1, projection optical system PL is, for example, a reduction system that is double telecentric, and in the system a refraction optical system made up of a plurality of lens elements 70a, 70b, ... and so forth having a common optical axis in the Z-axis direction is used. The pupil surface of projection optical system PL has a positional relationship conjugate with a secondary light source, which is formed by the fly-eye lens, and as well as a positional relationship based on the Fourier transform with the pattern surface of the reticle. In addition, as projection optical system PL, a system that has a projection magnification $\gamma$ of, for example, 1/4, 1/5, or 1/6 is used. Therefore, when illumination area IAR on reticle R is illuminated with exposure light EL as is previously described, an image of the pattern formed on reticle R reduced by the projection magnification $\gamma$ is projected and transferred onto a slit-shaped exposure area IA on wafer W which surface is coated with a resist (photosensitive agent) with projection optical system PL.

Of the above plurality of lens elements, a plurality of lens elements including a lens element 70a arranged closest to reticle R is independently drivable. For example, lens element 70a is supported with a ring shaped support member 76a, which is supported at three points with expandable drive elements such as piezo elements 74a, 74b, and 74c (drive element 74c located in the depth of the page surface in Fig. 1 is not shown), and is also joined to a barrel portion 76b. Drive elements 74a, 74b, and 74c allow the three points in the periphery of lens element 70a to move independently along a direction of the optical axis AX of projection optical system PL. That is, lens element 70a can be moved in parallel along optical axis AX in correspondence with an amount of displacement of the three drive elements 74a, 74b, and 74c, as well as be inclined in any way with respect to a plane perpendicular to optical axis AX. Other drivable lens elements are also configured to be finely drivable along the direction of optical axis AX and in the inclination direction via a drive mechanism similar to that of lens element 70a. In the embodiment, by driving lens element 70a or the like, adjustment can be performed on, for example, Seidel's five aberrations (distortion, astigmatism, coma, spherical aberration, and curvature of field (focus)). In this case, the number of independent corrections possible of the image forming characteristics is in line with the number of the drivable lens elements.

In this case, the voltage that is to be applied to the drive elements driving the above lens element 70a or the like is controlled by an image forming characteristics correction controller 78 based on the instructions of main controller 50, and image forming characteristics correction controller 78 controls the amount of displacement of the drive elements. In addition, image forming characteristics correction controller 78 not only adjusts the aberration of projection optical system PL, but also operates to maintain the aberration of projection optical system PL constant to aberration changes that occur due to pressure change, absorption of illumination beams, or the like. Incidentally, in Fig. 1, optical axis AX of projection optical system PL refers to the optical axis of lens element 70b and that of other lens elements (not shown) that are fixed to barrel 76b.

In addition, in the embodiment where the light source used is a vacuum ultraviolet light source such as the $F_2$ laser that has an output wavelength of 157nm, gases along the optical path in projection optical system PL need to be replaced with rare gas such as helium, or nitrogen gas (low absorptive gas) that absorbs little of the vacuum ultraviolet light. Also, in an exposure apparatus comprising a vacuum ultraviolet light source, the material used for lens elements of projection optical system PL is limited to crystal materials such as fluorite that has a large thermal expansion coefficient. Accordingly, since the rise in temperature occurring when the lens elements absorb exposure light EL immensely affects the lens elements and the image forming characteristics of the projection optical system, in the embodiment, helium gas is used of the above low absorptive gases due to its large cooling effect.

As is shown in Fig. 1, one end of a gas supply pipeline 30 and an exhaust pipeline 31 are each connected to the barrel of projection optical system PL. The other end of gas supply pipeline 30 is connected to one end of a gas circulation unit (not shown) that exhausts the gas within the barrel, whereas the other end of exhaust pipeline 31 is connected to the other end of the gas circulation unit. The gas circulation unit creates a flow of helium gas in projection optical system PL at all times via gas supply pipeline 30 and exhaust pipeline 31, so that the gas inside the barrel is replaced with helium gas with high purity. With this operation, the concentration of absorptive gas inside the barrel is maintained under several ppm at all times. In addition, the gas circulation unit incorporates a gas purifying unit (not shown), which operates to maintain the concentration of the absorptive gas within the barrel below several ppm even when the helium gas is circulated and used for over a long period of time in a circulation route including the gas circulation unit and the inside of the barrel of projection optical system PL. Sensors such as a pressure sensor or an absorptive gas concentration sensor may be arranged inside the barrel, and based on measurement values of the sensor, the start/stop operation of a pump incorporated in the gas circulation unit can be controlled appropriately via a control unit (not shown).

Wafer stage WST is arranged in wafer chamber 40. Wafer chamber 40 is covered with a partition wall 41 joined with the barrel of the projection optical system PL without any gap, which isolates the gas inside from the outside. Partition wall 41 of wafer chamber 40 is formed of a material such as stainless steel (SUS), which releases only a small amount of gas when degassed. And, inside wafer chamber 40, a base BS is arranged horizontally.

Wafer stage WST is configured including an XY stage 34 and a wafer holder 35. XY stage 34 is driven two-dimensionally in the Y-axis direction, which is the scanning direction, and the X-axis direction (the direction perpendicular to the page surface in Fig. 1) perpendicular to the Y-axis direction with linear motors or the like. Wafer holder 35 is mounted on XY stage 34, and wafer holder 35 holds wafer W by electrostatic suction (or vacuum chucking) or the like. Wafer holder 35 is supported at three points, with for example, three actuators (such as voice coil motors), and can be independently driven in the Z-axis direction. This operation allows adjustment of the position in the Z-axis direction (focus position) and the inclination with respect to the XY plane of wafer W. In Fig. 1, parts such as the linear motor that drives XY stage 34 and the actuators that drive wafer holder 35 are all collectively shown as a wafer stage drive section 56.

In an exposure apparatus that uses exposure wavelength in the vacuum ultraviolet region, such as in this embodiment, the optical path from projection optical system PL to wafer W also needs to be replaced with nitrogen or rare gas so as to prevent the exposure light from being absorbed by the absorptive gas such as oxygen.

As is shown in Fig. 1, one end of a gas supply pipeline 32 and an exhaust pipeline 33 are each connected to partition wall 41 of wafer chamber 40. The other end of gas supply pipeline 32 and exhaust pipeline 33 are each connected to the helium gas supply unit (not shown). Helium gas having high purity is supplied to wafer chamber 40 from the helium gas supply unit via gas supply pipeline 32 at all times, whereas the gas within wafer chamber 40 is collected by the helium gas supply unit via exhausting pipeline 33. The helium gas is circulated and used in such manner. The helium gas supply unit incorporates a gas purifying unit, and the gas purifying unit operates so as to maintain concentration of gases other than the helium gas (that is, absorptive gases such as oxygen, water vapor, or organic substances) less than several ppm, even when the helium gas is circulated and used for over a long period of time in a circulation route including the nitrogen gas supply unit and the inside of wafer chamber 40. Sensors such as a pressure sensor or an absorptive gas concentration sensor may be arranged within wafer chamber 40, and based on measurement values of the sensor, the start/stop operation of a pump incorporated in the helium gas supply unit can be controlled appropriately via the control unit (not shown).

On the side wall in the -Y side of partition wall 41 of wafer chamber 40, a light transmittance window 38 is arranged. Likewise, although it is omitted in the drawings, a light transmittance window is also arranged on the side wall in the -X side (in depth of the page surface in Fig. 1) of partition wall 41. These light transmittance windows are structured, by forming windows (opening portions) in partition wall 41 and attaching light transmitting members to close the windows, in this case, a normal optical glass. When the windows are formed, in order to prevent gas leakage from the portion where the light transmitting member configuring light transmittance window 38 is attached to the window opening, sealing with a metal seal such as indium or copper, or a fluorocarbon resin is applied to the attached portion. As the above fluorocarbon resin, a fluorocarbon resin that has been degassed by undergoing heat treatment for two hours at a temperature of 80°c is preferably used.

On the edge portion on the -Y side of wafer holder 35, a Y movable mirror 52Wy consisting of a planar mirror is arranged, extending in the X-axis direction. On Y movable mirror 52Wy, measurement beams from a Y-axis laser interferometer 37Wy arranged outside wafer chamber 40 almost at a right angle to Y movable mirror 52Wy are projected, via light transmittance window 38. A detector which receives the light reflected off Y movable mirror 52Wy via light transmittance window 38 is arranged within the Y-axis laser interferometer 37Wy, thus detecting a position of the Y movable mirror 52Wy, that is, a Y position of the wafer R, with a position of a reference mirror arranged within the Y-axis laser interferometer 37Wy as a reference.

Similarly, although it is omitted in the drawings, on the edge portion on the -X side of wafer holder 35, an X movable mirror consisting of a planar mirror is arranged, extending in the Y-axis direction. And, similar as above, a position of the X movable mirror, that is, an X position of wafer W is detected with an X-axis interferometer (not shown) via the X movable mirror. Detection values (measurement values) of the above two laser interferometers are supplied to main controller 50, which controls the position of wafer stage WST based on the detection values of these interferometers via wafer stage drive section 56.

As is described, in the embodiment, since the laser interferometer, that is; the laser light source, optical members such as a prism, and the detector or the like, is arranged outside wafer chamber 40, there are no adverse effects on exposure even if a small amount of absorptive gas is generated from parts making up the laser interferometers such as the detector.

In the description above, the helium gas supply unit of reticle chamber 15 and wafer chamber 40 is structured with the gas purifying unit incorporated, however, a different structure may be employed, such as the gas purifying unit not being incorporated and the gas from reticle chamber 15 and wafer chamber 46 being exhausted via factory piping. Likewise, the gas circulation unit arranged in projection optical system PL may be of a similar configuration.

In addition, the inner surface of barrel of projection optical system PL is, for example, preferably coated with fluorocarbon resin, or a hard film (such as a ceramics film or a stainless film) which releases only a small amount of gas when degassed is preferably formed by plasma spray coating, or a chemically clean processing is preferably performed by electric field polishing. Also, as the material of the inner surface of the barrel, chemically clean materials such as stainless or Teflon (registered trademark) may be used.

Furthermore, as is shown in Fig. 1, a multiple focal position detection system (hereinafter referred to as a "wafer AF system") 60 is provided in exposure apparatus 100 in the embodiment. This system is based on an oblique incident method, made up of an irradiation system 60a that has a light source which on/off operation is controlled by main controller 50 and irradiates many imaging beams to an image forming surface of projection optical system PL from a direction incident by a predetermined angle with respect to the optical axis of projection optical system PL so as to form pinhole or slit images, and a photodetection system 60b which photo-detects the imaging beams reflected off the surface of wafer W and detects its Z position at each detection point. A detailed configuration of a multiple focal position detection system similar to wafer AF system in the embodiment is disclosed in, for example, Japanese Patent Application Laid-open 06-283403 and the corresponding U.S. Patent No. 5,448,332. The output of wafer AF system 60 is sent to main controller 50. As long as the national laws in designated states or elected states, to which this international application is applied, permit, the disclosures of the Japanese Patent Application Laid-open and the U. S. Patent cited above are fully incorporated herein by reference.

The control system is mainly formed of main controller 50, shown in Fig. 1. Main controller 50 is structured including a microcomputer (or a workstation) made up with parts such as a CPU (center processing unit), a ROM (read only memory), and a RAM (random access memory). Main controller 50 performs various control operations such as the ones described above. In addition, main controller 50 also controls operations such as synchronous scanning of reticle R and wafer W, and stepping operation of wafer W so that exposure is accurately performed.

More precisely, for example, during scanning exposure, main controller 50 controls the position and velocity of both reticle stage RST and wafer stage WST via reticle stage drive section 49 and wafer stage drive section 56; based on the measurement values of laser interferometers 37Ry and 37Wy, so that reticle R is scanned synchronously via reticle stage RST in the +Y direction (or -Y direction) at a velocity $V_R = V$ with wafer W via wafer stage WST scanned in the -Y direction (or +Y direction) with respect to exposure area IA at a velocity $VW = \gamma \cdot V$ ($\gamma$ is the projection magnification from reticle R to wafer W). And, as a matter of course, main controller 50 controls reticle holder 14B based on the measurement values of a reticle X interferometer and a wafer X interferometer (both of them not shown), so as to prevent positional errors from occurring between reticle R and wafer W.

In addition, when stepping operations are performed, main controller 50 controls the position of wafer stage WST via wafer stage drive section 56, based on the measurement values of laser interferometer 37Wy and wafer X interferometer (not shown).

Besides the above operations, main controller 50, for example, performs auto-focusing (automatic focus adjustment) and auto-leveling when scanning exposure (to be described later) is performed, based on detection results of reticle AF system 20 and wafer AF system 60, by controlling the Z position and the inclination to the XY plane of wafer holder 35 via wafer stage drive section 56. In addition, prior to exposure operations, main controller 50 sets a detection offset in reticle AF system 20 (or, performs calibration using the offset) based on the measurement results of reticle AF system 20, as well as adjust the image forming characteristics of projection optical system PL. Such points will be covered in the description below.

First, the method of setting a detection offset in reticle AF system 20 is described, along with the reason for setting the offset.

The reason for setting the offset in reticle AF system 20 is because, in short, in exposure apparatus 100 in the embodiment, hard pellicle 24 is attached to reticle R, as is previously described, which affects the accuracy when detecting the Z position of reticle R.

More particularly, in the following description, for the sake of convenience, exposure apparatus 100 is to have an arrangement so that reticle R is freely drivable in the Z-axis direction. In addition, as a premise, calibration of reticle AF system 20 is to be performed on initial setting as is shown in Fig. 4, so that a focus BF of projection optical system PL on the reticle side (object plane side) coincides with an incident position of a reflection beam $FB_2$ on the second photodetection unit S2 as well as a detection reference point O, in a state where either there is no hard pellicle 24 or a pellicle (soft pellicle) made up of a membrane made mainly from an organic matter much thinner than hard pellicle 24 is provided in the exposure apparatus. In the above premise, focus BF is set by maximizing an incident angle determined by a numerical aperture N.A. and projection magnification $\gamma$ of projection optical system PL of exposure light EL on pattern surface PF at a maximum angle $\alpha'$, and reflection beam $FB_2$ is the reflection beam of an imaging beam (detection beam) $FB_1$ emitted from irradiation system 20a of reticle AF system 20 reflected off pattern surface PF.

In this state, when hard pellicle 24 is inserted as is shown in Fig. 4, focus BF of projection optical system PL on the reticle side (object plane side) moves upward (in the +Z direction) by $\Delta Z_1$, to a position BF'. When hard pellicle is inserted, however, an optical axis of imaging beam $FB_1$ incident on the pattern surface is changed to $FB_1'$, while an optical axis of reflection beam $FB_2$ reflected off the pattern surface is changed to $FB_2'$. This means that reticle AF system 20 acknowledges detection reference point O when the pattern surface of reticle R is at a position referenced as PF' in Fig. 4. Accordingly, when reticle R is controlled in the Z-axis direction according to the detection result of the second photodetection unit S2 without any detection offset setting in reticle AF system 20 (the second photodetection unit S2), reticle R will be driven upward (in the +Z direction) by $\Delta Z_2$ and the position of pattern surface PF will be set at the position of reference PF'.

In this case, the focal plane on the reticle side, which is supposed to be a target on alignment, however, is a surface indicated as PF". This creates a defocused state of $\Delta Z_1$-$\Delta Z_2$=$\Delta Z$, therefore, in order to resolve the defocused state, an offset needs to be set at $\Delta Z$ to a Z target value, to which the reticle is aligned, based on the detection results of reticle AF system 20.

That is, an alignment target value is set by adding offset $\Delta Z$ to the detection result of the second photodetection unit S2, and when the setting is completed, reticle R is driven in the Z-axis direction based on the target value. With this arrangement, pattern surface PF of reticle R can be made to coincide the focal plane of projection optical system PL on the reticle side, which has moved to surface PF" due to the insertion of hard pellicle 24.

Accordingly, even when the exposure apparatus is an apparatus designed to use a reticle R without the hard pellicle 24, or an apparatus designed to use a reticle R which pattern surface is protected by the soft pellicle, a reticle R comprising hard pellicle 24 can be used without any problems by changing the relative space in between projection optical system PL and reticle R.

Incidentally, instead of setting the offset $\Delta Z$, reticle AF system can be re-calibrated, by adjusting the angle of inclination of the parallel plate in photodetection optical system L2 shown in Fig. 2 as is described earlier and shifting the optical axis of the reflection beam by $\Delta M$ (=$\Delta Z \cdot \sin\alpha$), which corresponds to the offset $\Delta Z$, as is shown with an arrow A in Fig. 4.

The above offset $\Delta Z$ and the amount of the optical axis shift $\Delta M$ are set uniquely, corresponding to a thickness t of hard pellicle 24. That is, the $\Delta Z_1$ previously described can be expressed as in the following function, when using an incident angle $\alpha'$ of exposure light EL, an outgoing angle $\beta'$ of exposure light EL entering hard pellicle 24 (set uniquely by the law of refraction, based on a refraction index n of hard pellicle 24 to exposure light EL and incident angle $\alpha'$), and thickness t.

$$\Delta Z_1 = f_1(\alpha', \beta', t) \tag{1}$$

Incidentally, function $f_1$ will be described further in a second embodiment.

In the case of the embodiment, since incident angle $\alpha'$ is a known constant, and refraction index n of fluorine doped quartz 24 to exposure light EL (a fluorine laser beam having a wavelength of 157nm) is also known, outgoing angle $\beta'$ is also a constant that can be easily obtained by calculation. Accordingly, $\Delta Z_1$ can be expressed as in equation (2) below.

$$\Delta Z_1 = K_1 \cdot t \tag{2}$$

In this case, $K_1$ is a proportionality constant that is set based on the above $\alpha'$ and $\beta'$.

Likewise, the following expression is possible.

$$\Delta Z_2 = K_2 \cdot t \tag{3}$$

In this case, $K_2$ is a proportionality constant that is set based on an incident angle $\alpha$ of the above detection beam and an outgoing angle $\beta$ of the detection beam entering hard pellicle 24.

Accordingly, offset $\Delta Z$ can be expressed as in the following equation, (4).

$$\Delta Z = \Delta Z_1 - \Delta Z_2 = (K_1 - K_2) \cdot t = K \cdot t \tag{4}$$

In this case, K is a proportionality constant that is defined by K= $K_1$-$K_2$.

Accordingly, offset $\Delta Z$ can be obtained immediately by equation (4), once thickness t of hard pellicle 24 is known.

In reticle AF system 20 in the embodiment, the first photodetection unit S1 receives the reflection beams of the imaging beam irradiated from irradiation system 20a, reflected off the upper and lower surfaces of hard pellicle 24, respectively, and the detection signals are each output to main controller 50. And, based on the detection signals from the first photodetection unit S1, main controller 50 can calculate the distance $\delta$ in between the incident points of the reflection beams reflected off the upper and lower surfaces of hard pellicle 24 on the photodetection surface of photodetection unit S1 (refer to Fig. 2).

Therefore, from the geometric relation shown in Fig. 2, when projection magnification of photodetection optical system L1 is set as D, $\delta$ satisfies the relation expressed in the equation below (5).

$$\delta = 2t \cdot D \cdot \tan\beta \cdot \cos\alpha \tag{5}$$

When equation (5) is modified, it can be expressed as follows:

$$t = \delta/(2D \cdot \tan\beta \cdot \cos\alpha) \tag{5'}.$$

And, when equation (5)' is substituted into equation (4), it can be expressed as follows:

$$\Delta Z = K \cdot \delta/(2D \cdot \tan\beta \cdot \cos\alpha) \tag{6}$$

Equation (6) can be expressed as in equation (7), when $K/(2D \cdot \tan\beta \cdot \cos\alpha)$ is expressed as a proportionality constant C.

$$\Delta Z = C \cdot \delta \tag{7}$$

So, in the embodiment, proportionality constant C is obtained in advance, and is stored within the RAM of main controller 50, along with equation (7). Accordingly, main controller 50 calculates the above $\delta$ based on the detection signals from the first photodetection unit S1, and can also perform calibration on reticle AF system 20 by immediately setting detection offset $\Delta Z$ of reticle AF system 20, based on equation (7), or by controlling the inclination of parallel plate 69 in photodetection optical system L2 so that the optical axis of the reflection beams shifts only by $\Delta M(=\Delta Z \cdot \sin\alpha)$. As is obvious from equation (5) and (5)', since $\delta$ is proportional to thickness t of hard pellicle 24, measuring $\delta$ means none other than measuring thickness t.

In the above description, reticle R is driven along the Z-axis direction for the sake of convenience, however in the embodiment, since exposure apparatus 100 does not have a Z-axis direction drive mechanism, in actual, main controller 50 performs the above calibration on reticle AF system 20 based on the detection results of the thickness of hard pellicle 24 prior to exposure. And, when scanning exposure is performed, main controller 50 calculates the defocus amount of pattern surface PF of reticle R based on the detection result of the second photodetection unit S2 in reticle AF system 20 on which calibration has been performed. Then, taking the detection results into account, main controller 50 controls the Z position of wafer holder 35 via wafer stage drive section 56 based on measurement values of wafer AF system 60 so that an optical distance between (the pattern surface of) reticle R and (the surface of) wafer W is maintained, or in other words, a conjugate relationship is maintained between reticle R and wafer W. More details on this will be referred to later in the description.

In addition, in exposure apparatus 100 in the embodiment, three detection points of reticle AF system 20 (irradiating points of the imaging beams) are provided in the illumination area where exposure light EL of pattern surface PF of reticle R is irradiated. Therefore, when pattern surface PF is inclined in the non-scanning direction (when there is a leveling error in the non-scanning direction), it can be detected. However, when the thickness of hard pellicle 24 differs in the non-scanning direction, the detection results may be similar to that of when there is a leveling error in the non-scanning direction of pattern surface PF. Therefore, even in such a case, thickness t of hard pellicle 24 corresponding to each detection point is detected in order to detect the defocus amount of pattern surface PF at each detection point, and based on the detection results calibration (or the setting of the detection offset) of the second photodetection unit S2 described earlier is performed.

In addition, when thickness t of the hard pellicle is precisely obtained in advance, detection of thickness t of the hard pellicle is not necessary. That is, when thickness t of the hard pellicle is measured before the reticle having the hard pellicle is carried to the exposure apparatus, then an operator may input thickness t of the hard pellicle measured in advance into the exposure apparatus (or to be more precise, into the RAM of main controller 50) via an input/output unit such as a console. And, based on the input, calibration of the second photodetection unit S2 may be performed. Or, instead of the operator performing the input, thickness t of the hard pellicle can be stored as barcode information on the reticle, and the barcode information can be read with a barcode reader when the reticle having the hard pellicle is carried into the exposure apparatus.

In addition, when hard pellicle 24 is inserted, not only does the focal position on the image plane side of projection optical system PL change, but also image forming characteristics such as spherical aberration, coma, distortion, and curvature of field change. Therefore, in the embodiment, a relational expression between thickness t of the pellicle (pattern protective member) serving as a parameter and the drive amount of the lens elements of projection optical PL for correcting each of the above aberrations is stored in advance in the RAM. The relational expression is obtained by experiments including exposure of the actual pattern onto wafer W, measuring the pattern image via projection optical system PL, and optical simulation performed in advance. And, prior to exposure, main controller 50 gives instructions to image forming characteristics correction controller 78 to correct each of the above aberrations of projection optical system PL, based on the thickness of the pellicle (when the thickness at the three detection points differ, then based on one of an average thickness of the three detection points, an average thickness of detection points on both ends, and the thickness of the detection point in the center) measured at a timing around the above calibration of reticle AF system 20. When the lens elements are driven to correct the image forming characteristics of projection optical system PL, this causes a change in focus as a side effect; however, this change is so small that it can be dismissed. In addition, in the embodiment, main controller 50 can also adjust the position of pattern surface PF of reticle R (refer to Fig. 4) with respect to the focal plane on the reticle side, PF", by giving instructions to image forming characteristics correction controller 78 and driving at least one of the plurality of lens elements 70a, 70b, and so forth configuring projection optical system PL along the Z-axis direction.

When correction of the above aberrations of projection optical system PL has been completed, operations in the exposure process begin in the following manner.

First of all, preparatory operations are performed, such as reticle alignment using a reticle microscope (not shown) and an off-axis alignment sensor (not shown) and baseline measurement by the alignment sensor. Then, fine alignment of wafer W (such as EGA (Enhanced Global Alignment)) using the alignment sensor is performed, and arrangement coordinates of a plurality of shot areas on wafer W are obtained.

Details on preparatory operations such as the above reticle alignment and baseline measurement are disclosed in, for example, Japanese Patent Application Laid-open No. 04-324923, and in the corresponding U.S. Patent No. 5,243,195. As for the following operation, EGA, details are disclosed in, Japanese Patent Application Laid-open No. 61-44429, and the corresponding U.S. Patent No. 4,780,617. As long as the national laws in designated states or elected states, to which this international application is applied, permit, each of the disclosures of the Japanese Patent Application Laid-open and the disclosures of the corresponding U.S. Patents cited above are fully incorporated herein by reference.

When preparatory operations for exposing wafer W is completed in the manner above, main controller 50 moves wafer stage WST to the starting position (acceleration starting position) for scanning exposure on the first shot area on wafer W based on the alignment results, while monitoring the measurement values of Y-axis laser interferometer 37Wy on the wafer side and an X-laser interferometer (not shown).

Then, main controller 50 begins scanning reticle stage RST and wafer stage WST in the Y direction, and when both the stages reach their target scanning velocity, exposure light EL begins to illuminate the pattern area of reticle R, starting the scanning exposure.

Main controller 50 synchronously controls reticle stage RST and wafer stage WST, especially during the above scanning exposure, so that movement velocity $V_R$ of reticle stage RST in the Y-axis direction and movement velocity $V_W$ of wafer stage WST in the Y-axis direction are maintained at a velocity ratio corresponding to projection magnification $\gamma$ of projection optical system PL.

Then, different areas of the pattern area of reticle R are sequentially illuminated with the ultraviolet pulse light, and when the entire pattern area is illuminated, scanning exposure of the first shot area on wafer W is complete. With this operation, the circuit pattern of reticle R is reduced and transferred onto the first shot area via projection optical system PL.

When scanning exposure of the first shot area is completed in the manner above, main controller 50 steps wafer stage WST in the X-axis and Y-axis directions and moves wafer stage WST to the starting position for scanning exposure on the second shot area. When the stepping operation is performed, main controller measures positional displacement of wafer stage WST in the X, Y, and θz directions realtime, based on the measurement values of Y-axis laser interferometer 37Wy on the wafer side and an X-laser interferometer. Then, based on the measurement results, main controller 50 controls the position of wafer stage WST so that the XY positional displacement is in a predetermined state.

In addition, based on the information on displacement of wafer stage WST in the θz direction, main controller 50 rotatably controls reticle holder 14B so as to compensate for rotational displacement error on the wafer W side.

Then, main controller 50 performs scanning exposure on the second shot area, likewise the scanning exposure described above.

In the manner described above, scanning exposure and stepping operations to expose the following shot area is repeatedly performed, and the circuit pattern of reticle R is sequentially transferred onto all the shot areas subject to exposure on wafer W.

During the scanning exposure, main controller 50 performs focus-leveling control in the following manner. That is, when displacement of pattern surface PF of reticle R from a detection reference position detected by second photodetection unit S2, which is an arbitrary unit of reticle AF system 20 that has completed calibration (referred to as "$S2_1$" for the sake of convenience), is expressed as Rz, and displacement from a detection reference position detected by the sensors of wafer AF system (60a and 60b) which detection points are points on wafer W corresponding to the detection points of second photodetection unit $S2_1$ or its neighboring area is expressed as Wz, then focus displacement $\Delta F$ can be expressed as follows.

$$\Delta F = Rz \times \gamma^2 - Wz \tag{8}$$

Main controller 50 then moves wafer holder 35 in the Z-axis direction so that $\Delta F$ becomes zero at all the detection points of reticle AF system 20, thus performing focus-leveling control so that an optical positional relationship between reticle R and wafer W is constantly maintained.

As is obvious in the description so far, in the embodiment, main controller 50 structures a computing unit, as well as a first calculation unit and a second calculation unit that make up the computing unit. Meanwhile, main controller 50 and reticle AF system 20 make up a detection unit that detects the thickness of hard pellicle 24 protecting pattern surface PF of reticle R. In addition, wafer holder 35, wafer stage drive section 56, and main controller 50 make up a correction unit that corrects the positional relationship between reticle R and wafer W, while image forming characteristics correction controller 78 and main controller 50 make up a correction unit that corrects optical properties of projection optical system PL.

As is described in the above description, with exposure apparatus 100 in the first embodiment, since it comprises a detection unit (20 and 50) for detecting the thickness of hard pellicle 24 that protects pattern surface PF of reticle R, the position of pattern surface PF of reticle R in the Z direction can be accurately detected according to the thickness of hard pellicle 24 detected by the detection units. In addition, exposure that takes into account the change that occurs in the image forming state of the image of circuit pattern PA of reticle R due to hard pellicle 24 can be performed. Accordingly, exposure with high precision can be performed, without being affected by the thickness (or the difference in thickness) of hard pellicle 24.

In addition, hard pellicle 24 is made of a transparent plate, which is a parallel plate, and the detection unit is configured including: irradiation system 20a, which irradiates a detection beam via hard pellicle 24 on pattern surface PF from a direction oblique to its normal at a predetermined angle $\alpha$; the first photodetection unit S1, which receives the reflection beams reflected off the surfaces of hard pellicle 24 on the side facing pattern surface PF and its opposite side and outputs the detection signals, respectively; and main controller 50, which calculates the thickness of hard pellicle 24 based on the detection signals from the first photodetection unit S1. Therefore, main controller 50 can detect the thickness of hard pellicle 24 and others such as the pattern protective member whenever necessary, based on the detection signals of the first photodetection unit S1.

Regarding the thickness of hard pellicle 24, not all hard pellicles have the same thickness, and a reticle without a pellicle may be used. In the embodiment, however, since exposure apparatus 100 has the capability of detecting the thickness of the pellicles, not only can a reticle without pellicle may be used, but also a plurality of types of pellicles such as a reticle with a hard pellicle or a reticle with a soft pellicle that have different thickness may be used without any serious problems.

In addition, in the embodiment, the detection unit includes the second photodetection unit S2, which receives the reflection beams reflected off pattern surface PF and outputs the detection signals, and the second photodetection unit S2 can be calibrated based on the thickness of hard pellicle 24. In addition, main controller 50 configuring the detection unit can calculate the thickness of the pattern protective member such as hard pellicle 24 based on the detection signals from the first photodetection unit S1, and based on the calculated thickness and the detection signals from the second photodetection unit S2, main controller 50 can also calculate the real Z position of pattern surface PF (a position in normal direction), in which positional displacement of pattern surface PF of reticle R caused by the influence of the thickness of the pattern protective member is corrected, as well as the real amount of defocus.

In addition, as is previously described, calibration (or setting of detection offset) of reticle AF system 20 and correction of optical properties of projection optical system P1 are performed prior to exposure in the embodiment, based on the thickness of the protective member such as hard pellicle 24 obtained based on the output of the first photodetection unit S1. Also, when scanning exposure is performed, the positional relationship (optical positional relationship) between reticle R and wafer W is corrected (adjusted) taking into account the detection values of reticle AF system 20 on which the above calibration and the like has been performed. Therefore, exposure with high precision can be performed without the exposure accuracy degrading due to defocusing.

In addition, in the embodiment, irradiation system 20a irradiates detection beams to a plurality of detection points in an area in pattern surface PF corresponding to exposure area IA of projection optical system PL, respectively, and the first and second photodetection units S1 and S2 are provided each individually corresponding to the plurality of detection points. And then, in the embodiment, main controller 50 calculates a thickness distribution of the protective member such as hard pellicle 24 by detection signals from the plurality of first photodetection units S1, and adjusts the inclination of wafer W with respect to a surface perpendicular to the optical axis direction of projection optical system PL, that is, performs leveling adjustment. Accordingly, exposure with high precision can be performed, without being affected by the thickness distribution of the hard pellicle.

In addition, in the embodiment, since exposure is performed with an energy beam such as an $F_2$ laser which wavelength is 157nm and belongs to the vacuum ultraviolet region, resolution of the projection optical system can be improved, which consequently allows fine patterns to be transferred onto the wafer with high resolution.

In the above first embodiment, as a method of correcting the effects that occur due to the thickness of the hard pellicle, the method of adjusting the positional relationship of the reticle and wafer, or adjusting the optical properties of the projection optical system by driving the lens elements in the projection optical system has been employed. However, the present invention is not limited to the methods described above, and such methods can be combined so that a total adjustment is performed.

<<Second Embodiment>>

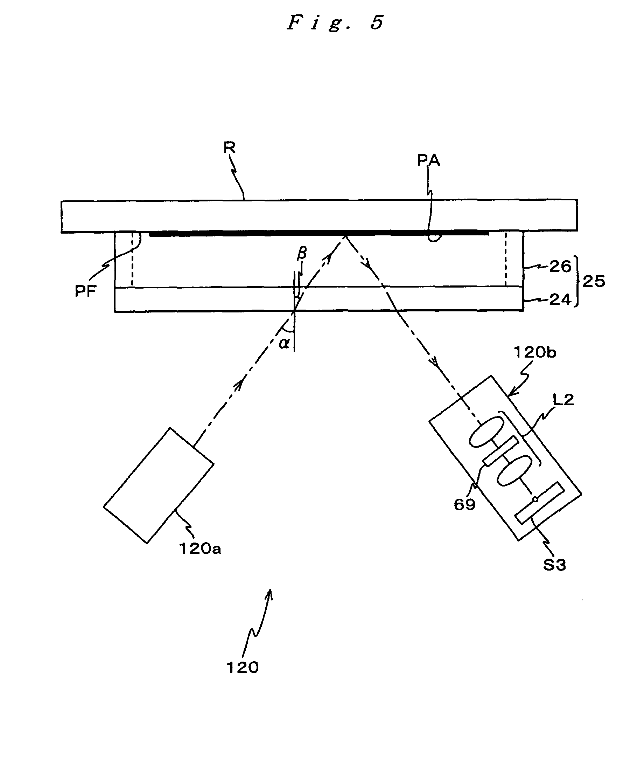

Next, a second embodiment of the present invention is described, referring to Figs. 5 to 7. Structures and components identical or equivalent to those described in the first embodiment are designated with the same reference numerals, and the description thereabout is briefly made or is entirely omitted.

In the second embodiment, an exposure apparatus is used that has a configuration similar to exposure apparatus 10 described in the first embodiment, except for the point that a reticle AF system 120 shown in Fig. 5 is provided instead of reticle AF system 20, and the control functions of main controller 50 slightly differs corresponding to the different system. Accordingly, the following description will be made focusing on the difference.

Fig. 5 shows an entire configuration of reticle AF system 120. As is shown, reticle AF system 120 comprises an irradiation system 120a, which configuration is similar to that of irradiation system 20a and irradiates detection beams on pattern surface PF of reticle R via hard pellicle 24, or in other words, irradiates imaging beams (red light belonging to the wavelength range of around 600nm to 800nm) for forming pinhole or slit images, and a photodetection system 120b, which is configured including a photodetection unit S3 or the like that receives reflection beams of the imaging beams emitted from irradiation system 120a reflected off pattern surface PF of reticle R via photodetection optical system L2.

As photodetection unit S3, a similar photodetection device as that of the second photodetection unit S2 is used. Photodetection unit S3 receives the reflection beams of imaging beams emitted from irradiation system 120a that are reflected off pattern surface PF of reticle R, and the detection signals are output to main controller 50. And, based on the detection signals, main controller 50 detects the position of pattern surface PF of reticle R in the optical axis direction. That is, in the embodiment, reticle AF system 120 and main controller 50 make up a position detection system.

Although it is not shown in Fig. 5, in actual, irradiation system 120a respectively irradiates imaging beams to a plurality of detection points arranged at a predetermined interval along the non-scanning direction (X-axis direction) in illumination area IAR of pattern surface PF of reticle R described earlier, and photodetection system 120b is provided individually corresponding to each of the detection points. Illumination system 120a and the plurality of photodetection systems 120b make up a multiple focal point detection system.

Configuration of other components is similar to that of the first embodiment. In the exposure apparatus in the second embodiment, incident angle $\alpha$ of the detection beams (imaging beams) from irradiation system 120a is set within a range of 35° to 40°. Following are the reasons for setting incident angle $\alpha$ within the range of 35° to 40°.

As a premise, as is shown in Fig. 6A, calibration on reticle AF system 120 is to be performed at initial setting, so that focus BF of projection optical system PL on the reticle side (object plane side) coincides with the incident position of reflection beam $FB_2$ on the third photodetection unit S3 as well as its detection reference point O, in a state where either there is no hard pellicle 24 or a soft pellicle is arranged in the exposure apparatus. In the above premise, focus BF is set by maximizing an incident angle determined by a numerical aperture N.A. and projection magnification $\gamma$ of projection optical system PL of exposure light EL on pattern surface PF at a maximum angle $\alpha'$, and reflection beam $FB_2$ is the reflection beam of an imaging beam (detection beam) $FB_1$ emitted from irradiation system 120a of reticle AF system 120 reflected off pattern surface PF.

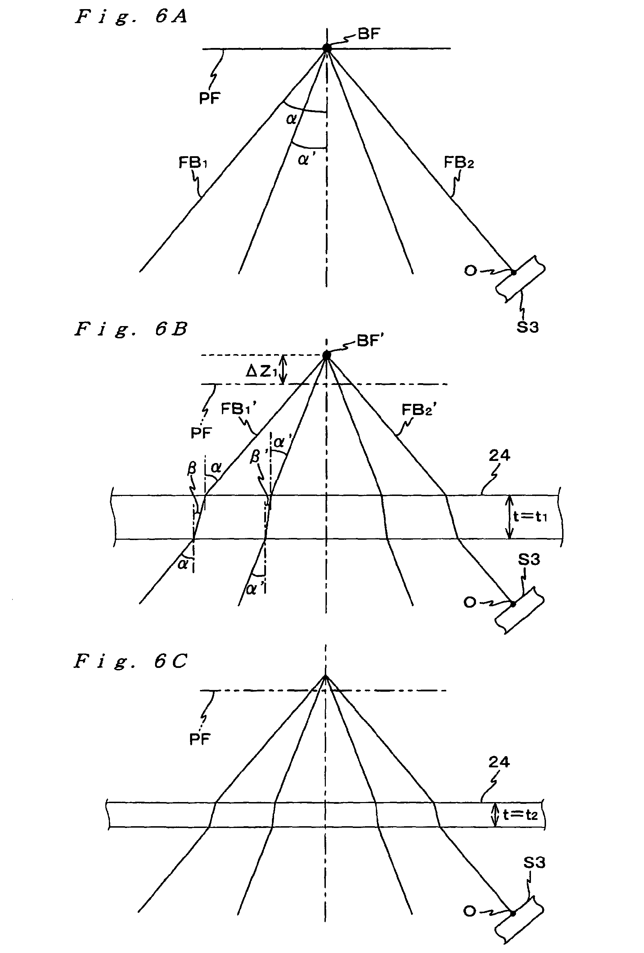

In this state, when hard pellicle (parallel plate glass) 24 is inserted as is shown in Fig. 6B, focus BF of projection optical system PL on the reticle side (object plane side) moves upward (in the +Z direction) by $\Delta Z_1$, to a position BF'. In this case, $\Delta Z_1$ can be expressed as function $f_1$ in equation (1) previously described, when using incident angle $\alpha'$ of exposure light EL, outgoing angle $\beta'$ of exposure light EL entering hard pellicle 24 (set uniquely by the law of refraction, based on refraction index n of hard pellicle 24 to exposure light EL and incident angle $\alpha'$), and thickness t.

However, it is acknowledged that an amount of change Z of the focal position of the imaging beams occurring due to the insertion of the parallel plate glass with thickness t near the object plane (or image plane) can be expressed in a typical equation that expresses a displacement in the focal position of an optical system including a parallel plate glass, as in equation (9) below.

$$Z=t(1-\tan\theta_2/\tan\theta_1) \tag{9}$$

In this case, $\theta_1$ is the incident angle of each beams to the parallel plate and $\theta_2$ is the outgoing angle of each beams entering the parallel plate glass. When the refraction index of parallel plate glass is set as n, due to the law of refraction, the relation between angles $\theta_1$ and $\theta_2$ can be expressed in the following manner:

$$\sin\theta_1=n\cdot\sin\theta_2 \tag{10}$$

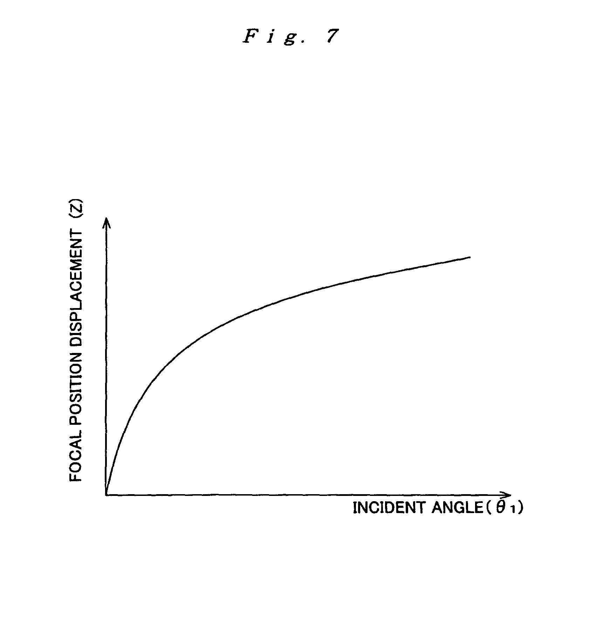

Displacement in focal position Z can be shown in a graph as in Fig. 7.

As is obvious from the description so far, function $f_1$ in equation (1) is none other than the function Z in the above equation (9), with the values $\theta_1=\alpha'$ and $\theta_2=\beta'$ replaced. Accordingly:

$$\Delta Z_1=f_1(\alpha',\ \beta',\ t)= t(1-\tan\beta'/\tan\alpha') \tag{1}'.$$

In addition, when the optical axis of imaging beam $FB_1$ incident on the pattern surface is changed to $FB_1'$ due to the insertion of hard pellicle 24, and pattern surface PF moves in the +Z direction by $\Delta Z_2$, reflection beam $FB_2'$ of the imaging beam reflected off the pattern surface of reticle R is to be received by an origin O in photodetection unit S3.

In this state, since equation (9) stands regardless of the wavelength of the beams, $\Delta Z_2$ can be expressed as in equation (11).

$$\Delta Z_2= t(1-\tan\beta/\tan\alpha) \tag{11}$$

In this case, $\alpha$ is an incident angle of the detection beam on hard pellicle 24, whereas $\beta$ is an outgoing angle of the detection beam entering hard pellicle 24 (the beam is refracted inside the glass).

However, since offset $\Delta Z$ that is to be set in reticle AF system 120 is $\Delta Z=\Delta Z_1-\Delta Z_2$, when $\Delta Z_1=\Delta Z_2$, that is, when the following equation (12) is established, then an offset setting will not be required.

$$t(1-\tan\beta'/\tan\alpha')= t(1-\tan\beta/\tan\alpha) \tag{12}$$

From this equation, when incident angle $\alpha$ satisfies the equation below:

$$\tan\beta'/\tan\alpha' = \tan\beta/\tan\alpha \tag{12}',$$

obviously, the offset setting of reticle AF system 120 is not required. So, in the following description, $\alpha$ used in the embodiment will be specifically obtained.

In projection optical system PL, numeric aperture (N.A.) on the wafer side is normally set within a range around 0.60 to 0.80, while numeric aperture (N.A.) on the reticle side is $\gamma$ (projection magnification) times the numeric aperture on the wafer side (or 1/imaging magnification from the wafer side to the reticle side). Therefore, since projection magnification $\gamma$ is 1/4 or 1/5, the numeric aperture on the reticle side is 0.60 x 1/5 to 0.8 x 1/4, that is around 0.12 to 0.20.

Since, numeric aperture = sin (incident angle) = $\sin\alpha'$, the maximum angle of the incident angle of the exposure beam on hard pellicle (parallel plate glass) 24 arranged in the vicinity of reticle R is calculated as follows:

$$\alpha'=\sin^{-1}(0.20) \fallingdotseq 11.5° \tag{13}.$$

For example, when exposure light EL is an $F_2$ laser beam having a wavelength of 157nm and the material of hard pellicle 24 is a fluorine-doped quartz, as in the embodiment, the refraction index of the fluorine-doped quartz to the $F_2$ laser beam is 1.65, therefore:

$$\tan\alpha' \fallingdotseq \tan(11.5°) \fallingdotseq 0.203 \tag{14}.$$

Due to the law of refraction:

$$\beta' = \sin^{-1}(\sin\alpha'/n)$$
$$\fallingdotseq \sin^{-1}(\sin(11.5°)/1.65)$$
$$\fallingdotseq 6.94° \qquad\qquad \cdots\cdots(15).$$

$$\tan\beta' \fallingdotseq \tan(6.94°) \fallingdotseq 0.122 \tag{16}$$

From these results, the above equation (1)' can be expressed as follows:

$$\Delta Z_1 \fallingdotseq t(1-0.122/0.203)=0.400 \times t \tag{17}.$$

That is, in this case, the displacement amount of the focal point of projection optical system PL on the reticle side is 40.0% of thickness t.

As the detection beam of reticle AF system 120 for detecting the position of reticle R, a red light belonging to the wavelength bandwidth of around 600 to 800nm is used. In a typical lens material, the refraction index of a long wavelength light is smaller than that of a short wavelength light. For example, the refraction index of a red light belonging to the wavelength bandwidth of around 600 to 800nm in a fluorine-doped quartz is about 1.45 to 1.46, which is small when compared with that of an $F_2$ laser beam, 1.65.

Accordingly, when incident angle $\alpha$ of the detection beam from the irradiation system 120a is set so that $\Delta Z_2$=t (1-tan$\beta$/tan$\alpha$) coincides with $\Delta Z_1$ (=0.400·t) to the exposure light ($F_2$ laser beam), the displacement in focal position of the exposure light ($F_2$ laser beam) that occurs due to the insertion of hard pellicle 24 coincides with the displacement of the detection position of the detection beam (red light), regardless of thickness t of hard pellicle 24. In this case, the above equation (12)' is valid.

That is, when focus correction is performed according to the detection results on the pattern position by reticle AF system 120, errors that occur due to various thickness of hard pellicle 24 can be avoided.

When the $F_2$ laser beam and hard pellicle 24 made of the fluorine-doped quartz is used as is described above, in the case incident angle $\alpha$ of the detection beam from the irradiation system 120a is in the range of 35° to 40° (corresponding to the refraction index 1.45 to 1.46), the detection error is around 40.0% of thickness t of hard pellicle 24. In order to visually show this point, incident angle $\alpha'$ of exposure light EL is set at 11° and incident angle $\alpha$ of the detection beam is set at 40° in Figs. 6B and 6C. As is obvious from Figs. 6B and 6C, by setting incident angle $\alpha$ of the detection beam so that the above equation (12)' is valid, the displacement in focal position of the exposure light ($F_2$ laser beam) that occurs due to the insertion of hard pellicle 24 is made to coincide with the displacement of the detection position of the detection beam (red light), regardless of thickness t of hard pellicle 24.

In the embodiment, by setting incident angle $\alpha$ of the detection beam in the range of 35° to 40°, the Z value of exposure light EL coincides with that of the detection beam of reticle AF system 120, creating a condition where errors caused by the thickness variation of hard pellicle 24 can be ignored.

Such a relation is not limited only to when the $F_2$ laser is used as the light source and the parallel plate is made of fluorine-doped quartz. For example, even when an ArF excimer light source and a hard pellicle made of quartz or fluorite is used, by optimizing incident angle $\alpha$ of the detection beams in various conditions so that the above Z of the exposure light coincides with that of the detection beams irradiated from the irradiation system, the detection values of reticle R obtained by the detection beams of the reticle AF system is substantially free of any influence from errors caused by the thickness (or by the various thickness) of the hard pellicle, similarly as is described above.

In addition, when the $F_2$ laser is used as the light source, the material of the hard pellicle is not limited only to the above fluorine-doped quartz, but a typical type of quartz, quartz containing less hydroxyl, or furthermore, hydrogen added quartz can also be used. In addition, fluoride crystal such as fluorite, magnesium fluoride, or lithium fluoride may also be used.

In addition, in the exposure apparatus in the second embodiment, three detection points (irradiation points of the imaging beams) of reticle AF system 120 are provided in the illumination area on pattern surface PF of reticle R on which exposure light EL is irradiated, and the incident angle of each of the imaging beams (the detection beams) is set within 30 to 40°. Therefore, photodetection unit S3, which receives the reflection beam of each detection beam, can accurately detect the amount of defocus at corresponding detection points without setting the detection offset (and performing the re-calibration previously described) and without considering whether hard pellicle 24 is provided in the apparatus or not. Thus, when pattern surface PF is inclined in the non-scanning direction (when a leveling error occurs in the non-scanning direction), such state can be detected.

However, when hard pellicle 24 is inserted, not only does the focal position of projection optical system PL on the side of the image plane change, but image forming characteristics such as spherical aberration, coma, distortion, and curvature of field also change. Accordingly, in order to correct the image forming characteristics of the projection optical system, information on thickness t of hard pellicle 24 is necessary. The information on thickness t, in the embodiment, is to be input by an operator via an input unit such as a console (not shown).

In the second embodiment, a relational expression between thickness t of the pellicle (pattern protective member) serving as a parameter and the drive amount of the lens elements of projection optical PL for correcting each of the above aberrations is stored in advance in the RAM, likewise the first embodiment. And, when information on thickness t of hard pellicle 24 is input via the input device such as a console (not shown) prior to exposure, main controller 50 gives instructions to image forming characteristics correction controller 78 to correct each of the above aberrations of projection optical system PL. Incidentally, when the lens elements are driven to correct the image forming characteristics of projection optical system PL, this causes a change in focus as a side effect; however, this change is so small that it can be dismissed.

Then, in a procedure similar to the one described in the first embodiment, operations in the exposure process are performed, and during scanning exposure, main controller 50 performs focus leveling control similar to the one described in the first embodiment and moves wafer holder 35 in the Z-axis direction, so that by making $\Delta F$ in the above equation (8) become zero at all detection points of reticle AF system 120 the optical positional relationship between reticle R and wafer W is constantly maintained.

As is described in the above description, according to the second embodiment, reticle AF system 120 can detect the amount of defocus of the reticle pattern surface with high precision, without being affected by whether a pattern protective member such as hard pellicle 24 is provided or not, and by the thickness (or the difference in thickness) when the pattern protective member is provided. And, since correction (adjustment) of the positional relationship (the optical positional relationship) between reticle R and wafer W is performed considering the detection values of reticle AF system 120, exposure with high precision is possible, free of any degrading in exposure accuracy due to defocusing.

In addition, in the second embodiment, since exposure is performed with an energy beam belonging to the vacuum ultraviolet region, such as the $F_2$ laser having a wavelength of 157nm, resolution in projection optical system PL can be improved, and fine patterns can be transferred onto the wafer with high resolution.

In the above second embodiment, incident angle $\alpha$ of the detection beams on reticle R is set within the range of 35° to 40°, however the present invention is not limited to this and the range may be set within the range of 30° to 50°.

In the second embodiment, the correction of image forming characteristics variation in the projection optical system is performed based on the information of thickness t of hard pellicle 24 input by the operator via a console or the like (not shown). However, the present invention is not limited to this, and the image forming characteristics variation in the projection optical system may be corrected by measuring the thickness of hard pellicle 24 using a reticle AF system having a similar structure as reticle AF system 20 in the first embodiment, and performing correction based on the measurement values.

In addition, in each of the embodiments above, wafer W (wafer holder) is driven when performing focus control (including leveling control). However, the present invention is not limited to this, and reticle R may be driven instead. In such a case, for example, the reticle stage may be structured including: a reticle coarse movement stage that is driven in the scanning direction by a linear motor; a reticle fine movement stage that is arranged on the reticle coarse movement stage and has a rectangular frame shape, being finely drivable within an XY plane by a voice coil motor or the like; and a reticle holder that holds reticle R by suction and is supported at three points on the reticle fine movement stage, being drivable in a Z direction and a direction of inclination with respect to the XY plane by an electromagnetic drive source such as a voice coil motor. And, when focus control (including leveling control) is performed, the reticle holder can be driven.

In addition, in each of the above embodiments, the case has been described where detection offset is set in the reticle AF system according to the thickness of the pattern protective member such as hard pellicle 24, or calibration is performed in the reticle AF system. The present invention, however, is not limited to this, and a similar operation effect can be obtained when an operation such as setting a detection offset in the wafer AF system according to the thickness of the pattern protective member such as hard pellicle 24 is performed.

In addition, in each of the above embodiments, the case has been described where the optical properties of the projection optical system are corrected by driving the lens elements that structure projection optical system PL. The present invention, however, is not limited to this, and aberrations can be corrected by vertically moving reticle R itself within a capture range of reticle AF system 20 or reticle AF system 120 based on instructions given by main controller 50, and the position of the reticle may be referred to as a reference position from then onward.

In each of the above embodiments, correction of focal position, correction of image forming characteristics in projection optical system PL, and leveling adjustment are each described separately, however, as a matter of course, it is possible to combine and perform these operations comprehensively, based on the detection results of the reticle AF system.

In each of the above embodiments, three photodetection systems (and irradiation systems) are provided in the reticle AF system, however, the present invention is not limited to this. In addition, in each of the above embodiments, the direction in which thickness distribution of the hard pellicle is measured by the plurality of reticle AF systems is the non-scanning direction, however, the present invention is not limited to this, and the measurement direction can be in the scanning direction, or a direction diagonal to the scanning direction/non-scanning direction.

In addition, the thickness of the hard pellicle may be measured by moving the reticle in the scanning direction with respect to the three photodetection systems of reticle AF system.

In addition, in each of the above embodiments, the space enclosed with pattern surface PF and frame 26 is also replaced with low absorptive gas. However, when the thickness of the protective member is detected, a red light belonging to the wavelength bandwidth of around 600 to 800nm is used, therefore, the space does not necessarily have to be replaced with the low absorptive gas.

In addition, in the above embodiments, the structure has been described where the inside of reticle chamber 15, the inside of wafer chamber 40, and the inside of the barrel of projection optical system PL are replaced with helium gas. The present invention, however, is not limited to this and the insides may be replaced with nitrogen gas, or only the inside of the barrel of projection optical system PL may be replaced with helium gas.

The light source of the exposure apparatus in the above embodiment is not limited to an $F_2$ laser light source, an ArF excimer laser light source, a KrF excimer laser light source, or the like. For example, a harmonic may be used as the light source, which is obtained by amplifying a single-wavelength laser beam in the infrared or visible range emitted by a DFB semiconductor laser or fiber laser, with a fiber amplifier doped with, for example, erbium (or both erbium and ytteribium), and by converting the wavelength into ultraviolet light using a nonlinear optical crystal. In addition, the magnification of the projection optical system is not limited to a reduction system, and both a system of equal magnification or enlarged magnification may be used.

In the above embodiments, the case has been described where the present invention is applied to a scanning exposure apparatus based on a step-and-scan method or the like. The scope of this invention to which it is applied, naturally, is not limited to this. That is, the present invention can be suitably applied to a reduction projection exposure apparatus based on a step-and-repeat method.

In addition, as the levitation method of wafer stage WST and reticle stage RST, a method making use of a levitation force caused by a gas flow can be used, naturally, instead of magnetic levitation, however, in such a case, the gas provided for stage levitation is preferably the low absorptive gas that fills each of the stage chambers.

The exposure apparatus in the embodiments above related to the present invention, such as exposure apparatus 100, can be made by incorporating the illumination optical system made up of a plurality of lenses and the projection optical system into the main body of the exposure apparatus and performing optical adjustment, while incorporating the wafer stage (and the reticle stage in the case of the scanning exposure apparatus) that are made up of various mechanical components into the main body of the exposure apparatus, connecting the wiring and piping, assembling each of the partition walls configuring the reticle chamber and the wafer chamber, connecting the gas piping system, connecting each portion to the control system, and furthermore, performing total adjustment (electrical adjustment, operational adjustment). The exposure apparatus is preferably made in a clean room in which temperature, degree of cleanliness, and the like are controlled.

<<Device Manufacturing Method>>

An embodiment of a device manufacturing method using the above exposure apparatus in a lithographic process is described next.

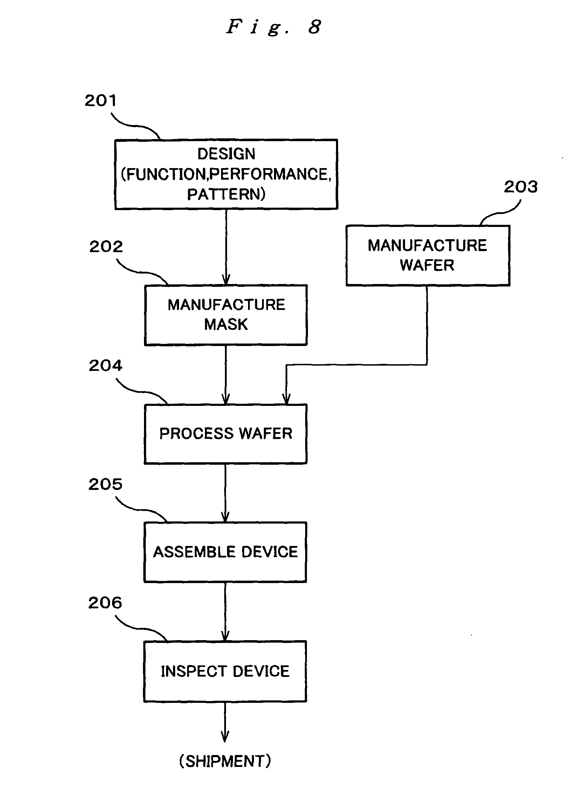

Fig. 8 is a flow chart showing an example of manufacturing a device (a semiconductor chip such as an IC or LSI, a liquid crystal panel, a CCD, a thin magnetic head, a micromachine, or the like). As shown in Fig. 8, in step 201 (design step), function/performance is designed for a device (e.g., circuit design for a semiconductor device) and a pattern to implement the function is designed. In step 202 (mask manufacturing step), a mask on which the designed

**EP 1 341 221 A1**

circuit pattern is formed is manufactured, whereas, in step 203 (wafer manufacturing step), a wafer is manufacturing by using a silicon material or the like.

In step 204 (wafer processing step), an actual circuit and the like is formed on the wafer by lithography or the like using the mask and wafer prepared in steps 201 to 203, as will be described later. Next, in step 205 (device assembly step) a device is assembled using the wafer processed in step 204. The step 205 includes processes such as dicing, bonding, and packaging (chip encapsulation), as necessary.

Finally, in step 206 (inspection step), a test on the operation of the device, durability test, and the like are performed. After these steps, the device is completed and shipped out.

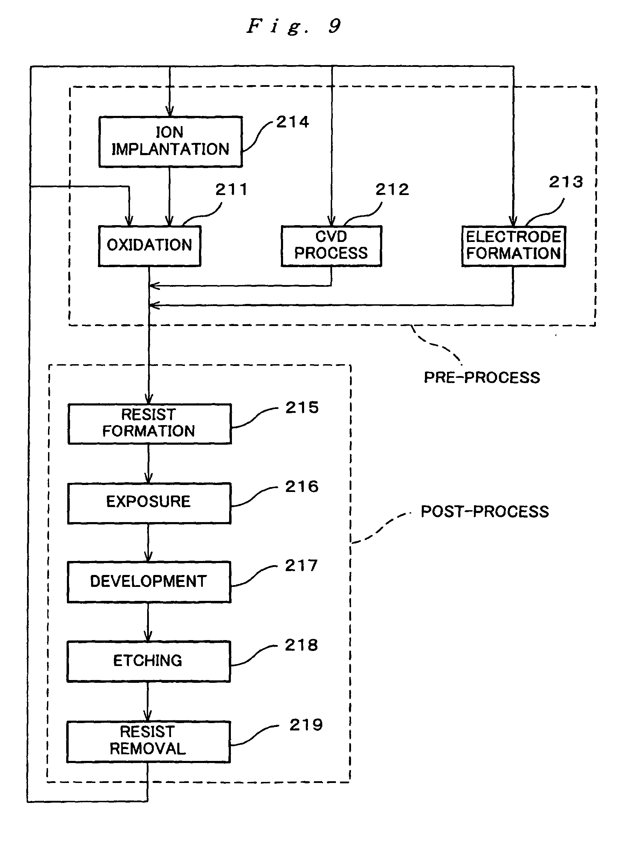

Fig. 9 is a flow chart showing a detailed example of step 204 described above in manufacturing the semiconductor device. Referring to Fig. 9, in step 211 (oxidation step), the surface of the wafer is oxidized. In step 212 (CVD step), an insulating film is formed on the wafer surface. In step 213 (electrode formation step), an electrode is formed on the wafer by vapor deposition. In step 214 (ion implantation step), ions are implanted into the wafer. Steps 211 to 214 described above constitute a pre-process for the respective steps in the wafer process and are selectively executed based on the processing required in the respective steps.

When the above pre-process is completed in the respective steps in the wafer process, a post-process is executed as follows. In this post-process, first, in step 215 (resist formation step), the wafer is coated with a photosensitive agent. Next, as in step 216, the circuit pattern on the mask is transferred onto the wafer by the lithography system (exposure apparatus) and exposure method described in the above embodiments. And, in step 217 (development step), the wafer that has been exposed is developed. Then, in step 218 (etching step), an exposed member of an area other than the area where the resist remains is removed by etching. Finally, in step 219 (resist removing step), when etching is completed, the resist that is no longer necessary is removed.

By repeatedly performing these pre-process and post-process steps, multiple circuit patterns are formed on the wafer.

When using the device manufacturing method described so far in the embodiment, since the exposure apparatus in the above embodiments is used in the exposure process (step 216), the pattern of the reticle can be transferred onto the wafer with high precision. As a consequence, the productivity (including yield) of high integration microdevices can be improved.

## INDUSTRIAL APPLICABILITY

As is described, the first to third exposure apparatus in the present invention and the first to fourth exposure methods in the present invention are suitable for performing exposure with high precision, without being affected by the thickness of the light transmitting protective member protecting the pattern surface of the mask. In addition, the device manufacturing method related to the present invention is suitable for producing high integration microdevices.

## Claims

1. An exposure apparatus that irradiates an energy beam on a mask and transfers a pattern formed on said mask onto a substrate, said exposure apparatus comprising:

   a detection unit that detects the thickness of a light transmitting protective member protecting a pattern surface of said mask on which said pattern is formed.

2. The exposure apparatus of Claim 1 wherein
   said light transmitting protective member is made from a transparent plate made of a parallel plate, and
   said detection unit has
   an irradiation system that irradiates a detection beam with respect to said pattern surface from an oblique direction at a predetermined angle via said transparent plate,
   a first photodetection unit that receives a first reflection beam and a second reflection beam reflected off a surface facing said pattern surface of said transparent plate and a surface on the opposite side of said surface, respectively, and outputs detection signals, respectively, and
   a computing unit that calculates the thickness of said transparent plate based on said detection signals output from said first photodetection unit.

3. The exposure apparatus of Claim 2 wherein
   said detection unit further has a second photodetection unit that receives a third reflection beam reflected off said pattern surface and outputs its detection signal, and

said computing unit further calculates a position of said pattern surface in a normal direction, based on detection signals output from said first photodetection unit and detection signal output from said second photodetection unit.

4. The exposure apparatus of Claim 3 wherein said computing unit includes

a first calculation unit that calculates the thickness of said transparent plate, based on detection signals output from said first photodetection unit, and
a second calculation unit that calculates a position of said pattern surface in a normal direction, based on the thickness of said transparent plate calculated by said first calculation unit and detection signal output from said second photodetection unit.

5. The exposure apparatus of Claim 3 wherein
said detection unit further has a calibration unit that calibrates said second photodetection unit, based on detection signals output from said first photodetection unit.

6. The exposure apparatus of Claim 5 wherein
said calibration unit calibrates said second photodetection unit by shifting an optical axis of a reflection beam reflected off said pattern surface.

7. The exposure apparatus of Claim 6 wherein
said calibration unit includes a parallel plate arranged along an optical path of said reflection beam from said pattern surface to said second photodetection unit, and inclination of said parallel plate can be changed with respect to said optical axis of said reflection beam.

8. The exposure apparatus of Claim 2, further comprising:

a projection optical system which is arranged so that its optical axis is made to match said normal direction, and projects said energy beam outgoing from said mask onto said substrate; and
a correction unit that corrects at least one of a positional relationship between said mask and said substrate and optical properties of said projection optical system, based on the thickness of said transparent plate calculated by said computing unit.

9. The exposure apparatus of Claim 8 wherein
said irradiation system irradiates detection beams onto each of a plurality of detection points within an area on said pattern surface that corresponds to an exposure area of said projection optical system illuminated by said energy beam,
said first photodetection units are arranged in plurals, individually corresponding to each of said plurality of detection points,
said computing unit calculates a distribution of thickness of said transparent plate, based on detection signals from said plurality of first detection units, and
said correction unit adjusts an inclination of at least one of said mask and said substrate with respect to a surface perpendicular to said optical direction of said projection optical system.

10. An exposure apparatus that irradiates an energy beam on a mask and transfers a pattern formed on said mask onto a substrate, said exposure apparatus comprising:

a position detection system that has

an irradiation system that irradiates a detection beam on a pattern surface of said mask on which said pattern is formed at an incident angle $\alpha$ via a light transmitting transparent plate, which has a predetermined thickness and protects said pattern surface,
a photodetection unit that receives a reflection beam reflected off said pattern surface and outputs its detection signal, and
a calculation unit that calculates a position of said pattern surface in a normal direction of said pattern surface, based on an output of said photodetection unit; and

a projection optical system which optical axis is in said normal direction and projects said energy beam outgoing from said mask onto said substrate, whereby

when an outgoing angle of said detection beam entering said transparent plate is expressed as $\beta$, a maximum angle of an incident angle of said energy beam to said transparent plate is expressed as $\alpha'$, said maximum angle of said incident angle of said energy beam being set by a numeric aperture and a projection magnification of said projection optical system, and an outgoing angle of said energy beam entering said transparent plate is expressed as $\beta'$, said incident angle $\alpha$ is set to satisfy a relation expressed as:

$$\tan\beta/\tan\alpha = \tan\beta'/\tan\alpha'.$$

11. The exposure apparatus of Claim 10 wherein
said energy beam is an $F_2$ laser beam having a wavelength of 157nm, and
said incident angle $\alpha$ is set within the range of 30° to 50°.

12. The exposure apparatus of Claim 11 wherein said incident angle $\alpha$ is set within the range of 35° to 40°.

13. The exposure apparatus of Claim 11 wherein
said detection beam is a red light that belongs to the wavelength bandwidth of 600nm to 800nm, and
said transparent plate is made of a fluorine-doped quartz.

14. The exposure apparatus of Claim 10, further comprising:

a correction unit that corrects optical properties of said projection optical system based on a thickness t of said transparent plate.

15. The exposure apparatus of Claim 14, further comprising:

a detection unit that detects said thickness t.

16. An exposure apparatus that irradiates an energy beam on a mask and transfers a pattern formed on said mask onto a substrate, said exposure apparatus comprising:

an irradiation system that irradiates a detection beam on a pattern surface of said mask on which said pattern is formed from a direction of a predetermined angle of inclination via a light transmitting transparent plate, which has a predetermined thickness and protects said pattern surface;
a position detection unit that receives a reflection beam reflected off said pattern surface, and detects a position of said pattern surface in a normal direction, and
a calibration unit that calibrates said position detection unit, based on the thickness of said transparent plate.

17. The exposure apparatus of Claim 16, further comprising:

a thickness detection unit that detects the thickness of said transparent plate, wherein

said calibration unit calibrates said position detection unit, based on detection results of said thickness detection unit.

18. A device manufacturing method including a lithographic process, wherein in said lithographic process exposure is performed using any one of said exposure apparatus of Claims 1 to 17.

19. An exposure method in which an energy beam exposes a substrate via a mask on which a pattern is formed to transfer an image of said pattern on said substrate, said exposure method including:

a detection process in which the thickness of a light transmitting protective member protecting a pattern surface of said mask where said pattern is formed is detected; and
a correction process in which an image forming state of said pattern is corrected, based on said thickness of said light transmitting protective member detected in said detection process.

**20.** The exposure method of Claim 19 wherein
said light transmitting protective member is made from a transparent plate made of a parallel plate, and said detection process includes

an irradiation process in which a detection beam is irradiated from a direction of a predetermined inclination with respect to a normal line of said pattern surface via said transparent plate
a photodetection process in which a first reflection beam and a second reflection beam reflected off a surface facing said pattern surface of said transparent plate and a surface on the opposite side of said surface facing said pattern surface are received, respectively, and
a calculation process in which said thickness of said transparent plate is calculated based on detection results of said first and second reflection beams.

**21.** The exposure method of Claim 20 wherein
in said photodetection process, a third reflection beam from said pattern surface is further received, and
in said calculation process, a position of said pattern surface in said normal direction is further calculated, based on photodetection results of said first, second, and third reflection beams.

**22.** The exposure method of Claim 21 wherein
calculating a position of said pattern surface in said normal direction includes

a first calculation process in which the thickness of said transparent plate is calculated, based on said photodetection results of said first and second reflection beams,
a second calculation process in which said position of said pattern surface in said normal direction is calculated, based on said calculated thickness of said transparent plate and photodetection result of said third reflection beam.

**23.** An exposure method in which an energy beam is irradiated on a mask, and a pattern formed on said mask is transferred onto a substrate via a projection optical system, said exposure method including:

a process of irradiating a detection beam on a pattern surface of said mask on which said pattern is formed at an incident angle $\alpha$ via a light transmitting transparent plate, which has a predetermined thickness and protects said pattern surface; and
a process of calculating a position of said pattern surface in an optical axis direction of said projection optical system, which is a normal direction of said pattern surface, when a reflection beam reflected off said pattern surface is received, based on its results, whereby

when an outgoing angle of said detection beam entering said transparent plate is expressed as $\beta$, a maximum angle of an incident angle of said energy beam to said transparent plate is expressed as $\alpha'$, said maximum angle of said incident angle of said energy beam being set by a numeric aperture and a projection magnification of said projection optical system, and an outgoing angle of said energy beam entering said transparent plate is expressed as $\beta'$, said incident angle $\alpha$ is set to satisfy a relation expressed as:

$$\tan\beta/\tan\alpha = \tan\beta'/\tan\alpha'.$$

**24.** An exposure method in which an energy beam having a wavelength of 157nm is irradiated on a mask, and a pattern formed on said mask is transferred onto a substrate via a projection optical system, said exposure method including:

a process of irradiating a detection beam on a pattern surface of said mask on which said pattern is formed in an incident angle range of 30° to 50°; and
a process of calculating a position of said pattern surface in an optical axis direction of said projection optical system when a reflection beam of said detection beam reflected off said pattern surface is received, based on its results.

**25.** The exposure method of Claim 24 wherein
said incident angle is an angle in the range of 35° to 40°.

26. An exposure method in which an energy beam is irradiated on a mask, and a pattern formed on said mask is transferred onto a substrate, said exposure method including:

an irradiation process in which a detection beam is irradiated on a pattern surface of said mask on which said pattern is formed from a direction of a predetermined angle of inclination via a light transmitting transparent plate, which has a predetermined thickness and protects said pattern surface; and

a position detection/correction process in which a position of said pattern surface in a normal direction is detected when a reflection beam reflected off said pattern surface is received and said position of said pattern surface in said normal direction is corrected, based on the thickness of said transparent plate.

27. The exposure method of Claim 26, further including:

a detection process detecting the thickness of said transparent plate, and

in said position detection/correction process, correcting said position of said pattern surface in said normal direction is performed, based on the thickness of said transparent plate detected in said detection process.

28. The exposure method of Claim 26 wherein in said position detection/correction process, said position of said pattern surface in said normal direction is detected using a position detection unit, and said position detection unit is calibrated to correct said position, based on the thickness of said transparent plate.

29. A device manufacturing method including a lithographic process, wherein in said lithographic process exposure is performed using any one of said exposure methods of Claims 19 to 28.

30. (New) The exposure apparatus of Claim 1 wherein said detection unit further detects a position of said pattern surface in a normal direction.

31. (New) The exposure apparatus of Claim 30 wherein said light transmitting protective member is made from a transparent plate made of a parallel plate, and said detection unit has

an irradiation system that irradiates a detection beam with respect to said pattern surface from an oblique direction at a predetermined angle via said transparent plate,

a photodetection unit that receives a reflection beam reflected off said pattern surface and outputs its detection signal, and

a computing unit that calculates a position of said pattern surface in a normal direction, based on the thickness of said protective member and detection signal output from said photodetection unit.

32. (New) The exposure apparatus of Claim 1 wherein said detection unit detects the thickness of said light transmitting protective member at a plurality of points.

33. (New) The exposure apparatus of Claim 32, further comprising:

a correction unit that corrects at least one of a positional relationship between said mask and said substrate and optical properties of said projection optical system, based on the thickness of said protective member detected by said detection unit at said plurality of points.

34. (New) The exposure apparatus of Claim 33 wherein said correction unit corrects at least one of a positional relationship between said mask and said substrate and optical properties of said projection optical system, based on an average value of the thickness of said protective member thickness detected at said plurality of points.

35. (New) The exposure apparatus of Claim 16, further comprising:

a barcode reader that reads information on the thickness of said transparent plate stored in said mask as a barcode, and

said calibration unit calibrates said position detection unit, based on results read by said barcode reader.

36. (New) The exposure apparatus of Claim 17 wherein said calibration unit corrects a position of said pattern surface in a normal direction detected by said position detection unit.

*Fig. 1*

Fig. 2

$F i g . \ 3$

Fig. 4

EP 1 341 221 A1

*Fig. 5*

Fig. 6A

Fig. 6B

Fig. 6C

33

*F i g . 7*

*Fig. 8*

201 → DESIGN
(FUNCTION,PERFORMANCE, PATTERN)

203 → MANUFACTURE WAFER

202 → MANUFACTURE MASK

204 → PROCESS WAFER

205 → ASSEMBLE DEVICE

206 → INSPECT DEVICE

(SHIPMENT)

*Fig. 9*

EP 1 341 221 A1

## INTERNATIONAL SEARCH REPORT

| | International application No. |
|---|---|
| | PCT/JP01/10184 |

A. CLASSIFICATION OF SUBJECT MATTER
   Int.Cl⁷   H01L21/027, G03F7/20

According to International Patent Classification (IPC) or to both national classification and IPC

B. FIELDS SEARCHED

Minimum documentation searched (classification system followed by classification symbols)
   Int.Cl⁷   H01L21/027, G03F7/20

Documentation searched other than minimum documentation to the extent that such documents are included in the fields searched
   Jitsuyo Shinan Koho          1926-1996     Toroku Jitsuyo Shinan Koho   1994-2001
   Kokai Jitsuyo Shinan Koho    1971-2001     Jitsuyo Shinan Toroku Koho   1996-2001

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| A | JP 11-45846 A (Nikon Corporation), 16 February, 1999 (16.02.1999), Full text; all drawings   (Family: none) | 1-29 |
| A | JP 9-180989 A (Toshiba Corporation), 11 July, 1997 (11.07.1997), Full text; all drawings & KR 253054 B | 1-29 |
| A | JP 7-29802 A (Nikon Corporation), 31 January, 1995 (31.01.1995), Full text; all drawings & US 5581324 A | 1-29 |
| A | JP 4-254319 A (Hitachi, Ltd.), 09 September, 1992 (09.09.1992), Full text; all drawings & US 5166529 A       & US 5209813 A | 1-29 |

☐ Further documents are listed in the continuation of Box C.   ☐ See patent family annex.

* Special categories of cited documents:
"A" document defining the general state of the art which is not considered to be of particular relevance
"E" earlier document but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed

"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

Date of the actual completion of the international search
   28 December, 2001 (28.12.01)

Date of mailing of the international search report
   15 January, 2002 (15.01.02)

Name and mailing address of the ISA/
   Japanese Patent Office

Authorized officer

Facsimile No.

Telephone No.

Form PCT/ISA/210 (second sheet) (July 1992)

37